(19)

Europäisches
Patentamt
European
Patent Office
Office européen
des brevets

(11) **EP 4 572 139 A1**

(12) **EUROPEAN PATENT APPLICATION**

(43) Date of publication:
**18.06.2025 Bulletin 2025/25**

(51) International Patent Classification (IPC):
*H03F 3/45* (2006.01)    *H03F 3/195* (2006.01)
*H03F 1/14* (2006.01)

(21) Application number: **24209790.5**

(22) Date of filing: **30.10.2024**

(52) Cooperative Patent Classification (CPC):
**H03F 3/45475; H03F 1/14; H03F 3/195;
H03F 3/211; H03F 3/45179;** H03F 2200/451;
H03F 2203/45134

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.12.2023  US 202318539347**

(71) Applicant: **Intel Corporation
Santa Clara, CA 95054 (US)**

(72) Inventors:
• **AGRAWAL, Abhishek
  Portland OR, 97229 (US)**
• **CALLENDER, Steven
  Denver CO, 80206 (US)**
• **BHAT, Ritesh A.
  Portland OR, 97210 (US)**

(74) Representative: **Viering, Jentschura & Partner
mbB
Patent- und Rechtsanwälte
Am Brauhaus 8
01099 Dresden (DE)**

(54) **METHODS AND DEVICES INCLUDING AMPLIFIER CIRCUITRY**

(57)    An amplifier circuitry, operable in radio frequency signals, such as mmWave and sub-THz signals, may include an array of differential pair amplifiers connected between differential input connections and differential output connections extending on a plane. Through a configuration including sub-arrays having different pair configurations and respective connections configured to mitigate magnetic feedback currents of the respective sub-arrays, the amplifier circuitry may obtain a higher output power and stability in comparison to conventional amplifier arrays.

FIG. 7

# Description

## Technical Field

Various aspects of this disclosure relate to an amplifier circuitry for radio communication.

## Background

The complexity of communication systems continues to increase in order to meet the requirements of the market and the users in terms of many aspects, including speed, reliability, energy efficiency, coverage, and scalability. Recent communication systems may require many inter-related components, blocks, or functions working together in order to perform improvements to such aspects in communication elements such as receivers, transmitters, or alternatively transceivers for devices that may transmit and receive communication signals. One of the exemplary reasons for the recent challenges in communication systems may be considered as the recent implementation of radio communication using signals having frequencies over one gigahertz. The communication may generally take the form of radio communication at such frequencies, however other forms of transmission mediums may also be used, such as wired communication, satellite communication, or optical communication.

To support increases in data traffic, transceivers need to support wider bandwidths (BW) and higher-order modulations schemes. Furthermore, it is also desired that the transceivers would spend energy efficiently and have reduced complexity. Further, considering the employment of millimeter waves (mmWave) and sub-terahertz (sub-THz) frequencies associated with portions of the electromagnetic spectrum characterized by wavelengths ranging from approximately 1 millimeter down to submillimeter sizes, there may be room for development of amplifier circuitries with improved power and stability.

## Brief Description of Figures

In the drawings, like reference characters generally refer to the same parts throughout the different views. The drawings are not necessarily to scale, emphasis instead generally being placed upon illustrating the principles of the disclosure. In the following description, various aspects of the disclosure are described with reference to the following drawings, in which:

FIGs. 1 and 2 depict a general network and device architecture for wireless communications;
FIG. 3 shows an exemplary illustration of various communication elements of an apparatus for a wireless communication device;
FIG. 4 shows schematically a block diagram of an example radio frequency (RF) front end circuit;
FIG. 5 shows schematically an example of a RF transceiver circuitry;
FIG. 6 shows schematically an example of an amplifier circuitry in accordance with various aspects provided herein;
FIG. 7 shows schematically an exemplary illustration of two subarrays of an amplifier circuitry;
FIG. 8A and FIG. 8B show exemplary illustration of plots of maximum stable gain (MSG) or maximum available gain (MAG) vs. neutralization capacitance $C_{nu}$;
FIG. 9 shows schematically an exemplary illustration of two subarrays of an amplifier circuitry in accordance with various aspects of this disclosure;
FIG. 10 shows an exemplary illustration of a graph associated with simulated gain and stability factor;
FIG. 11 shows schematically another exemplary illustration of two subarrays of an amplifier circuitry;
FIG. 12 shows an exemplary illustration of a graph associated with simulated gain and stability factor.

## Description

Power amplifiers (PAs) may be used in RF circuits to provide amplification to communication signals. High data rate (10+ Gb/s) communication may be enabled by the large available spectrum at mmWave/-sub-THz (e.g. 30 - 300 GHz) frequencies. Radio communication devices operating at these frequencies may use medium-to-high power (Psat > +5dBm) power amplifiers (PA) in a single radio frequency (RF) chain or in multiple RF-chains (e.g. within phased arrays) to compensate path loss thereby restoring healthy link budget. In view of various constraints associated with such operational frequencies, medium-to-high power PAs at mmWave/subTHz frequency may be challenging due to increased passive loss and limited device gain.

For example, at such higher frequencies like mmWave and sub-THz, passive components of RF-chains, such as transmission lines, filters, and matching networks may exhibit higher insertion loss which may result in a considerable effect for the overall power efficiency of the amplifier. Further, amplifier circuitries configured for such operational frequencies may require active devices like gallium nitride (GaN) or gallium arsenide (GaAs) transistors. However, these devices might have limited gain at such operational frequencies, which may result in employing multiple stages of amplification or complex circuitries to achieve desired power levels.

Furthermore, during employment of higher power levels, thermal dissipation may become a concern for stability. Heat management becomes crucial to maintain the reliability and performance of the amplifier, especially considering the compact sizes often required in modern electronics. Moreover, nonlinear behavior in active devices may become more prominent at these frequencies, which may affect the linearity and distortion characteristics of the amplifier circuitry.

Especially, magnetic coupling effects at mmWave/sub-THz frequencies may significantly impact the performance of systems and components operating within these ranges. Illustratively, traces and conductors on a printed circuit board (PCB) or within an integrated circuit can exhibit increased inductive behavior at higher frequencies due to their physical dimensions becoming comparable to the wavelength of the signals. This may lead to unintended coupling between different parts of a circuit, such as different portions of an amplifier circuitry. Magnetic fields generated by high-frequency signals can induce currents in nearby conductive elements, which may lead to unintentional radiation and crosstalk between adjacent traces, components, or circuits. This can degrade the signal quality and overall performance of the system through the propagation of magnetic feedback currents.

It is further to be considered that certain materials, including conductors and dielectrics, might exhibit increased magnetic losses at these frequencies. Such magnetic losses can lead to reduced efficiency in components and devices, in particular of amplifier circuitry, impacting their performance as they interact with magnetic fields. Magnetic effects may further influence the resonance behavior of circuits and antennas, affecting impedance matching and tuning at specific frequencies. Achieving the desired impedance matching may become critical for maximizing power transfer and signal integrity amidst magnetic feedback currents.

In accordance with various aspects of this disclosure, an amplifier circuitry may use first magnetic feedback currents generated in accordance with magnetic coupling as described above at a first section of the amplifier circuitry to mitigate (e.g. cancel out, at least partially) second magnetic feedback currents generated at a second section of the amplifier circuitry. In particular, an amplifier circuitry including substantially identical-structured multiple amplifier circuits.

Substantially identical structures may include substantially same physical layout of amplifier circuits (e.g. components within the amplifier circuits are arranged in the same (or substantially the same) manner, following a similar layout and placement), and/or substantially same electrical characteristics (e.g. components such as transistors, resistors, or capacitors of the amplifier circuits have identical or substantially identical specifications or values to cause each circuit to perform similarly), and/or substantially same functional design (i.e. the amplifier circuits operate in the same way (or substantially the same way) by utilizing similar configurations and principles to achieve comparable functionality and performance.

Through obtained high degree of similarity in how the amplifier circuits are built as described above, arranged, and operate within the amplifier circuitry, generally a uniform performance, a balanced load sharing, and/or a reduction of manufacturing complexity may be obtained. In accordance with various aspects provided in this disclosure, as substantially identical structures of an amplifier circuitry including first amplifier circuits and second amplifier circuits, magnitude of magnetic feedback currents generated by the first amplifier circuits may resemble magnitude of magnetic feedback currents generated by the second amplifier circuits. In a singular illustration, magnetic coupling associated with a first amplifier circuit and may resemble magnetic coupling associated with a second amplifier circuit in magnitude, as associated components such as input and output connections may be coupling each other similarly due to their substantially identical structures. In pluralities, illustratively the first amplifier circuits may include N number of amplifier circuits and the second amplifier circuits may also include N number of amplifier circuits, which may result in similar magnitudes of magnetic feedback currents.

In accordance with various aspects provided herein, the amplifier circuitry may be configured, such that magnitude feedback currents generated by the first amplifier circuits may mitigate (e.g. cancel out, at least partially) magnitude feedback currents generated by the second amplifier circuits to reduce their effect within the amplifier circuitry and outside of the amplifier circuits, some of which have been described above. In other words, the magnitude feedback currents, generated by the first set of amplifier circuits within an amplifier circuitry, may oppose or partially offset the magnitude feedback currents produced by the second set of amplifier circuits. It is to be noted that, due to the nature of the feedback mechanisms and variations within the circuits, complete cancellation might not occur.

In some examples, the above-mentioned aspects may be particularly beneficial for amplifier circuitries with repeating structures. Exemplarily, an amplifier circuitry may be or may include a Neutralized Differential Pair (NDP) array including multiple NDPs, which may be implemented within an integrated circuits or on a printed circuit board (PCB). In an amplifier circuit, a differential pair configuration may include two active devices (usually transistors) that may be configured to amplify the difference between two input signals while rejecting common-mode signals. Such a configuration may be commonly used because of its balanced characteristics and its ability to reduce noise and certain distortions. However, in high-frequency circuits, parasitic capacitances and inductances may result in unwanted oscillations or instability of the amplifier circuit, particularly at higher frequencies.

An NDP may be used to counteract such unwanted effects. An NDP may include one or more neutralization components (which may include circuits) to intentionally introduce feedback to cancel out the parasitic effects through neutralization of the reactance in the differential pair. By neutralizing the differential pair, the aim may be to maintain the desired amplification of the differential signal while suppressing or eliminating potential instabilities or oscillations caused by parasitic elements, especially in high-frequency applications where such effects can be more pronounced. It is particularly important to achieve stable and reliable performance in RF and high-frequency amplifier designs.

An NDP array may include multiple NDPs to collectively provide higher amplification levels by combining the differential signals from multiple pairs. When NDPs are provided in an array, differential pairs can work together to maintain stability, reduce unwanted oscillations, and improve the overall performance of the system, especially in high-frequency applications where instability may be a concern. Furthermore, an NDP array may be scaled up or down to meet different desired requirements, allowing for flexibility in design and application.

At mmWave or sub-THz frequencies, the physical dimensions of an NDP array may quickly become comparable to the operational wavelength of the signals, which may increase the impact of distributed effects of the interconnect over device, resulting in parasitic inductance and increased magnetic feedback between the input and output connections. These effects may degrade both gain and stability, and place a practical limit on the NDP array size for a given operating frequency thereby limiting the attainable output power.

Traditionally, array size of an NDP array may be limited to reduce such effects, resulting in a lower gain and output power. Additionally, or alternatively, an NDP may include additional interconnects through multiple parallel NDP arrays, which may introduce further complexity for design and implementation. For example, an NDP array may be implemented via traditional power combining methods via designated controlled impedance interfaces for isolation. However, these approaches may have certain fallbacks.

Illustratively, intentional reduction in attainable output power may result to err on the side of amplifier stability. In the case of a PA in a transmitter, this may limit the distance over which the communication can be established. For phased-arrays, a larger number of antennas may be required in order to reach the total desired radiated power. If the array size of an NDP array is limited, but connected in parallel to further NDP arrays, then the interconnect added at the input and output may introduce further loss which may degrade gain and reduce the final available power at the output. Designer may require additional caution to ensure stability of the fully connected amplifier as this interconnect can exacerbate stability issues.

Through use of Wilkinson power combiners, these structures may utilize controlled impedance distribution (transmission lines) to combine the outputs of multiple amplifier chains while also providing isolation between chains. This isolation may be considered to be critical as it improves stability over some traditional methods. However, these transmission lines may occupy larger area than the compact methods above, so there is a direct area penalty. This area penalty can limit the number of transceivers that can be co-integrated on silicon, which can be disadvantageous for phased-array systems.

In accordance with various aspects described in this disclosure, an amplifier circuitry including one or more NDP arrays configured for mmWave and/or sub-THz frequencies may be provided. The one or more NDP array may, through implementation of various aspects described herein, mitigate (e.g. cancel out, at least partially), both capacitive and magnetic feedbacks from output to input in order to improve stability and preserve the gain enhancement, which may result in higher power devices in a single channel amplifier.

Illustratively, for a PA design at sub-THz frequencies (100+ GHz) which may require sufficiently high output power with robust stability, less process, voltage and temperature (PVT) sensitivity and wider bandwidth. Through implementation of various aspects described herein, larger NDP arrays at mmWave/sub-THz frequencies may be provided in order to realize these higher power PAs. For mm-Wave PA (e.g. 20-70GHz), although the magnetic feedback may be considered to be less severe for a given array size due to the lower frequency of operation in comparison with sub-THZ operation, typically at these frequencies, higher output power may be desirable which may require increasing the array size of the amplifier circuitry. In accordance with various aspects described herein, array size of the amplifier circuitry may be increased while still yielding improved stability.

The apparatuses and methods of this disclosure may utilize or be related to radio communication technologies. While some examples may refer to specific radio communication technologies, the examples provided herein may be similarly applied to various other radio communication technologies, both existing and not yet formulated, particularly in cases where such radio communication technologies share similar features as disclosed regarding the following examples. Various exemplary radio communication technologies that the apparatuses and methods described herein may utilize include, but are not limited to: a Global System for Mobile Communications ("GSM") radio communication technology, a General Packet Radio Service ("GPRS") radio communication technology, an Enhanced Data Rates for GSM Evolution ("EDGE") radio communication technology, and/or a Third Generation Partnership Project ("3GPP") radio communication technology, for example Universal Mobile Telecommunications System ("UMTS"), Freedom of Multimedia Access ("FOMA"), 3GPP Long Term Evolution ("LTE"), 3GPP Long Term Evolution Advanced ("LTE Advanced"), Code division multiple access 2000 ("CDMA2000"), Cellular Digital Packet Data ("CDPD"), Mobitex, Third Generation (3G), Circuit Switched Data ("CSD"), High-Speed Circuit-Switched Data ("HSCSD"), Universal Mobile Telecommunications System ("Third Generation") ("UMTS (3G)"), Wideband Code Division Multiple Access (Universal Mobile Telecommunications System) ("W-CDMA (UMTS)"), High Speed Packet Access ("HSPA"), High-Speed Downlink Packet Access ("HSDPA"), High-Speed Uplink Packet Access ("HSUPA"), High Speed Packet Access Plus ("HSPA+"), Universal Mobile Telecommunications System-Time-Division Duplex ("UMTS-TDD"), Time Division-Code Division Multiple Access ("TD-CDMA"), Time Division-Synchronous Code Division Multiple Access ("TD-CDMA"), 3rd Generation Partnership Project Release 8 (Pre-4th Generation) ("3GPP Rel. 8 (Pre-4G)"), 3GPP Rel. 9 (3rd Generation Partnership Project Release 9), 3GPP Rel. 10 (3rd Generation Partnership Project Release 10), 3GPP Rel. 11 (3rd Generation Partnership Project Release 11), 3GPP Rel. 12 (3rd Generation Partnership Project Release 12), 3GPP Rel. 13 (3rd Generation Partnership Project Release 13), 3GPP Rel. 14 (3rd Generation Partnership Project Release 14), 3GPP Rel. 15 (3rd Generation Partnership Project Release 15), 3GPP Rel. 16 (3rd Generation Partnership Project Release 16), 3GPP Rel. 17 (3rd Generation Partnership Project Release 17), 3GPP Rel. 18 (3rd Generation Partnership Project Release 18), 3GPP 5G, 3GPP LTE Extra, LTE-Advanced Pro, LTE Licensed-Assisted Access ("LAA"), MuLTEfire, UMTS Terrestrial Radio Access ("UTRA"), Evolved UMTS Terrestrial Radio Access ("E-UTRA"), Long Term Evolution Advanced (4th Generation) ("LTE Advanced (4G)"), cdmaOne ("2G"), Code division multiple access 2000 (Third generation) ("CDMA2000 (3G)"), Evolution-Data Optimized or Evolution-Data Only ("EV-DO"), Advanced Mobile Phone System (1st Generation) ("AMPS (1G)"), Total Access Communication arrangement/Extended Total Access Communication arrangement ("TACS/ETACS"), Digital AMPS (2nd Generation) ("D-AMPS (2G)"), Push-to-talk ("PTT"), Mobile Telephone System ("MTS"), Improved Mobile Telephone System ("IMTS"), Advanced Mobile Telephone System ("AMTS"), OLT (Norwegian for Offentlig Landmobil Telefoni, Public Land Mobile Telephony), MTD (Swedish abbreviation for Mobiltelefonisystem D, or Mobile telephony system D), Public Automated Land Mobile ("Autotel/PALM"), ARP (Finnish for Autoradiopuhelin, "car radio phone"), NMT (Nordic Mobile Telephony), High capacity version of NTT (Nippon Telegraph and Telephone) ("Hicap"), Cellular Digital Packet Data ("CDPD"), Mobitex, DataTAC, Integrated Digital Enhanced Network ("iDEN"), Personal Digital Cellular ("PDC"), Circuit Switched Data ("CSD"), Personal Handy-phone System ("PHS"), Wideband Integrated Digital Enhanced Network ("WiDEN"), iBurst, Unlicensed Mobile Access ("UMA"), also referred to as also referred to as 3GPP Generic Access Network, or GAN standard), Zigbee, Bluetooth®, Wireless Gigabit Alliance ("WiGig") standard, mmWave standards in general (wireless systems operating at 10-300 GHz and above such as WiGig, IEEE 802.11ad, IEEE 802.11ay, etc.), technologies operating above 300 GHz and THz bands, (3GPP/LTE based or IEEE 802.11p and other) Vehicle-to-Vehicle ("V2V") and Vehicle-to-X ("V2X") and Vehicle-to-Infrastructure ("V2I") and Infrastructure-to-Vehicle ("I2V") communication technologies, 3GPP cellular V2X, DSRC (Dedicated Short Range Communications) communication arrangements such as Intelligent-Transport-Systems, and other existing, developing, or future radio communication technologies.

The apparatuses and methods described herein may use such radio communication technologies according to various spectrum management schemes, including, but not limited to, dedicated licensed spectrum, unlicensed spectrum, (licensed) shared spectrum (such as LSA = Licensed Shared Access in 2.3-2.4 GHz, 3.4-3.6 GHz, 3.6-3.8 GHz and further frequencies and SAS = Spectrum Access System in 3.55-3.7 GHz and further frequencies), and may use various spectrum bands including, but not limited to, IMT (International Mobile Telecommunications) spectrum (including 450-470 MHz, 790-960 MHz, 1710-2025 MHz, 2110-2200 MHz, 2300-2400 MHz, 2500-2690 MHz, 698-790 MHz, 610-790 MHz, 3400-3600 MHz, etc., where some bands may be limited to specific region(s) and/or countries), IMT-advanced spectrum, IMT-2020 spectrum (expected to include 3600-3800 MHz, 3.5 GHz bands, 700 MHz bands, bands within the 24.25-86 GHz range, etc.), spectrum made available under FCC's "Spectrum Frontier" 5G initiative (including 27.5-28.35 GHz, 29.1-29.25 GHz, 31-31.3 GHz, 37-38.6 GHz, 38.6-40 GHz, 42-42.5 GHz, 57-64 GHz, 64-71 GHz, 71-76 GHz, 81-86 GHz and 92-94 GHz, etc.), the ITS (Intelligent Transport Systems) band of 5.9 GHz (typically 5.85-5.925 GHz) and 63-64 GHz, bands currently allocated to WiGig such as WiGig Band 1 (57.24-59.40 GHz), WiGig Band 2 (59.40-61.56 GHz) and WiGig Band 3 (61.56-63.72 GHz) and WiGig Band 4 (63.72-65.88 GHz), the 70.2 GHz-71 GHz band, any band between 65.88 GHz and 71 GHz, bands currently allocated to automotive radar applications such as 76-81 GHz, and future bands including 94-300 GHz and above. Furthermore, the apparatuses and methods described herein can also employ radio communication technologies on a secondary basis on bands such as the TV White Space bands (typically below 790 MHz) where e.g. the 400 MHz and 700 MHz bands are prospective candidates. Besides cellular applications, specific applications for vertical markets may be addressed such as PMSE (Program Making and Special Events), medical, health, surgery, automotive, low-latency, drones, etc. applications. Furthermore, the apparatuses and methods described herein may also use radio communication technologies with a hierarchical application, such as by introducing a hierarchical prioritization of usage for different types of users (e.g., low/medium/high priority, etc.), based on a prioritized access to the spectrum e.g., with highest priority to tier-1 users, followed by tier-2, then tier-3, etc. users, etc. The apparatuses and methods described herein can also use radio communication technologies with different Single Carrier or OFDM flavors (CP-OFDM, SC-FDMA, SC-OFDM, filter bank-based multicarrier (FBMC), OFDMA, etc.) and e.g. 3GPP NR (New Radio), which can include allocating the OFDM carrier data bit vectors to the corresponding symbol resources.

For purposes of this disclosure, radio communication technologies may be classified as one of a Short Range radio communication technology or Cellular Wide Area radio communication technology. Short Range radio communication technologies may include Bluetooth, WLAN (e.g., according to any IEEE 802.11 standard), and other similar radio communication technologies. Cellular Wide Area radio communication technologies may include Global System for Mobile Communications ("GSM"), Code Division Multiple Access 2000 ("CDMA2000"), Universal Mobile Telecommunications System ("UMTS"), Long Term Evolution ("LTE"), General Packet Radio Service ("GPRS"), Evolution-Data Optimized ("EV-DO"), Enhanced Data Rates for GSM Evolution ("EDGE"), High Speed Packet Access (HSPA; including High Speed Downlink Packet Access ("HSDPA"), High Speed Uplink Packet Access ("HSUPA"), HSDPA Plus ("HSDPA+"), and HSUPA Plus ("HSUPA+")), Worldwide Interoperability for Microwave Access ("WiMax") (e.g., according to an IEEE 802.16 radio communication standard, e.g., WiMax fixed or WiMax mobile), etc., and other similar radio communication technologies. Cellular Wide Area radio communication technologies also include "small cells" of such technologies, such as microcells, femtocells, and picocells. Cellular Wide Area radio communication technologies may be generally referred to herein as "cellular" communication technologies.

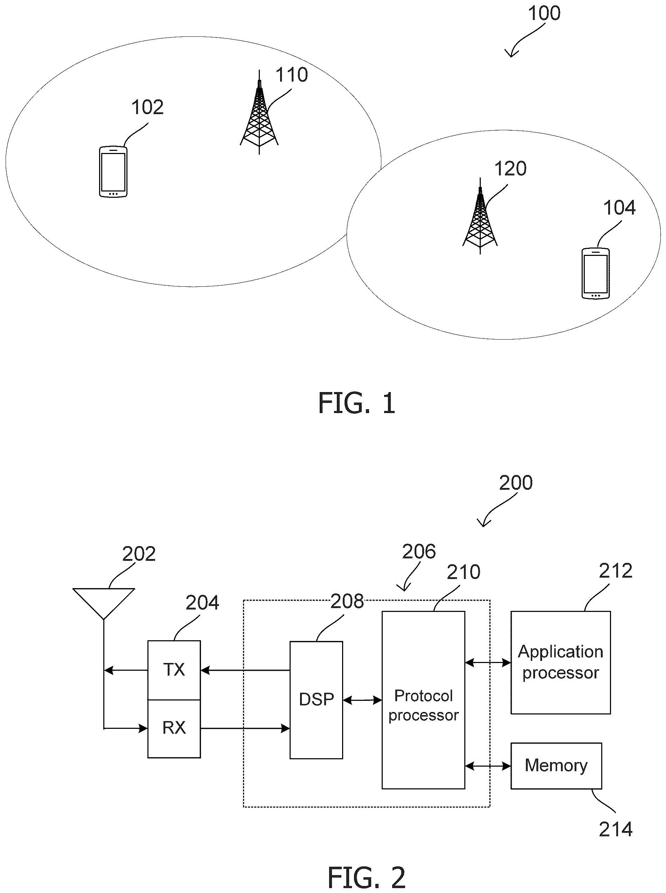

FIGs. 1 and 2 depict a general network and device architecture for wireless communications. In particular, FIG. 1 shows exemplary radio communication network 100 according to some aspects, which may include terminal devices 102 and 104 and network access nodes 110 and 120. Radio communication network 100 may communicate with terminal devices 102 and 104 via network access nodes 110 and 120 over a radio access network. Although certain examples described herein may refer to a particular radio access network context (e.g., LTE, UMTS, GSM, other 3rd Generation Partnership Project (3GPP) networks, WLAN/WiFi, Bluetooth, 5GNR, mmWave, etc.), these examples are demonstrative and may therefore be readily applied to any other type or configuration of radio access network. The number of network access nodes and terminal devices in radio communication network 100 is exemplary and is scalable to any amount.

In an exemplary cellular context, network access nodes 110 and 120 may be base stations (e.g., eNodeBs, NodeBs, Base Transceiver Stations (BTSs), gNodeBs, or any other type of base station), while terminal devices 102 and 104 may be cellular terminal devices (e.g., Mobile Stations (MSs), User Equipments (UEs), or any type of cellular terminal device). Network access nodes 110 and 120 may therefore interface (e.g., via backhaul interfaces) with a cellular core network such as an Evolved Packet Core (EPC, for LTE), Core Network (CN, for UMTS), or other cellular core networks, which may also be considered part of radio communication network 100. The cellular core network may interface with one or more external data networks. In an exemplary short-range context, network access node 110 and 120 may be access points (APs, e.g., WLAN or WiFi APs), while terminal device 102 and 104 may be short range terminal devices (e.g., stations (STAs)). Network access nodes 110 and 120 may interface (e.g., via an internal or external router) with one or more external data networks. Network access nodes 110 and 120 and terminal devices 102 and 104 may include one or multiple transmission/-reception points (TRPs).

Network access nodes 110 and 120 (and, optionally, other network access nodes of radio communication network 100 not explicitly shown in FIG. 1) may accordingly provide a radio access network to terminal devices 102 and 104 (and, optionally, other terminal devices of radio communication network 100 not explicitly shown in FIG. 1). In an exemplary cellular context, the radio access network provided by network access nodes 110 and 120 may enable terminal devices 102 and 104 to wirelessly access the core network via radio communications. The core network may provide switching, routing, and transmission, for traffic data related to terminal devices 102 and 104, and may further provide access to various internal data networks (e.g., control nodes, routing nodes that transfer information between other terminal devices on radio communication network 100, etc.) and external data networks (e.g., data networks providing voice, text, multimedia (audio, video, image), and other Internet and application data). In an exemplary short-range context, the radio access network provided by network access nodes 110 and 120 may provide access to internal data networks (e.g., for transferring data between terminal devices connected to radio communication network 100) and external data networks (e.g., data networks providing voice, text, multimedia (audio, video, image), and other Internet and application data).

The radio access network and core network (if applicable, such as for a cellular context) of radio communication network 100 may be governed by communication protocols that can vary depending on the specifics of radio communication network 100. Such communication protocols may define the scheduling, formatting, and routing of both user and control data traffic through radio communication network 100, which includes the transmission and reception of such data through both the radio access and core network domains of radio communication network 100. Accordingly, terminal devices 102 and 104 and network access nodes 110 and 120 may follow the defined communication protocols to transmit and receive data over the radio access network domain of radio communication network 100, while the core network may follow the defined communication protocols to route data within and outside of the core network. Exemplary communication protocols include LTE, UMTS, GSM, WiMAX, Bluetooth, WiFi, mmWave, etc., any of which may be applicable to radio communication network 100.

FIG. 2 shows an exemplary internal configuration of a communication device according to various aspects provided in this disclosure. The communication device may include various aspects of network access nodes 110, 120 or various aspects of a terminal device 102 as well. The communication device 200 may include antenna system 202, radio frequency (RF) transceiver 204, baseband modem 206 (including digital signal processor 208 and protocol controller 210), application processor 212, and memory 214. Although not explicitly shown in FIG. 2, in some aspects communication device 200 may include one or more additional hardware and/or software components, such as processors/microprocessors, controllers/microcontrollers, other specialty or generic hardware/processors/circuits, peripheral device(s), memory, power supply, external device interface(s), subscriber identity module(s) (SIMs), user input/output devices (display(s), keypad(s), touchscreen(s), speaker(s), external button(s), camera(s), microphone(s), etc.), or other related components.

Communication device 200 may transmit and receive radio signals on one or more radio access networks. Baseband modem 206 may direct such communication functionality of communication device 200 according to the communication protocols associated with each radio access network, and may execute control over antenna system 202 and RF transceiver 204 to transmit and receive radio signals according to the formatting and scheduling parameters defined by each communication protocol. Although various practical designs may include separate communication components for each supported radio communication technology (e.g., a separate antenna, RF transceiver, digital signal processor, and controller), for purposes of conciseness the configuration of communication device 200 shown in FIG. 2 depicts only a single instance of such components.

Communication device 200 may transmit and receive wireless signals with antenna system 202. Antenna system 202 may be a single antenna or may include one or more antenna arrays that each include multiple antenna elements. For example, antenna system 202 may include an antenna array at the top of communication device 200 and a second antenna array at the bottom of communication device 200. In some aspects, antenna system 202 may additionally include analog antenna combination and/or beamforming circuitry.

In the receive (RX) path, RF transceiver 204 may receive analog radio frequency signals from antenna system 202 and perform analog and digital RF front-end processing on the analog radio frequency signals to produce digital baseband samples (e.g., In-Phase/Quadrature (IQ) samples) to provide to baseband modem 206. RF transceiver 204 may include analog and digital reception components including amplifiers (e.g., Low Noise Amplifiers (LNAs)), filters, RF demodulators (e.g., RF IQ demodulators)), and analog-to-digital converters (ADCs), which RF transceiver 204 may utilize to convert the received radio frequency signals to digital baseband samples. In the transmit (TX) path, RF transceiver 204 may receive digital baseband samples from baseband modem 206 and perform analog and digital RF front-end processing on the digital baseband samples to produce analog radio frequency signals to provide to antenna system 202 for wireless transmission. RF transceiver 204 may thus include analog and digital transmission components including amplifiers (e.g., Power Amplifiers (PAs), filters, RF modulators (e.g., RF IQ modulators), and digital-to-analog converters (DACs), which RF transceiver 204 may utilize to mix the digital baseband samples received from baseband modem 206 and produce the analog radio frequency signals for wireless transmission by antenna system 202. In some aspects baseband modem 206 may control the radio transmission and reception of RF transceiver 204, including specifying the transmit and receive radio frequencies for operation of RF transceiver 204. In some aspects, RF transceiver 204 may include one or more amplifier circuitries as described in this disclosure, for example as PAs.

As shown in FIG. 2, baseband modem 206 may include digital signal processor 208, which may perform physical layer (PHY, Layer 1) transmission and reception processing to, in the transmit path, prepare outgoing transmit data provided by protocol controller 210 for transmission via RF transceiver 204, and, in the receive path, prepare incoming received data provided by RF transceiver 204 for processing by protocol controller 210. Digital signal processor 208 may be configured to perform one or more of error detection, forward error correction encoding/decoding, channel coding and interleaving, channel modulation/demodulation, physical channel mapping, radio measurement and search, frequency and time synchronization, antenna diversity processing, power control and weighting, rate matching/de-matching, retransmission processing, interference cancelation, and any other physical layer processing functions. Digital signal processor 208 may be structurally realized as hardware components (e.g., as one or more digitally-configured hardware circuits or FPGAs), software-defined components (e.g., one or more processors configured to execute program code defining arithmetic, control, and I/O instructions (e.g., software and/or firmware) stored in a non-transitory computer-readable storage medium), or as a combination of hardware and software components. In some aspects, digital signal processor 208 may include one or more processors configured to retrieve and execute program code that defines control and processing logic for physical layer processing operations. In some aspects, digital signal processor 208 may execute processing functions with software via the execution of executable instructions. In some aspects, digital signal processor 208 may include one or more dedicated hardware circuits (e.g., ASICs, FPGAs, and other hardware) that are digitally configured to specific execute processing functions, where the one or more processors of digital signal processor 208 may offload certain processing tasks to these dedicated hardware circuits, which are known as hardware accelerators. Exemplary hardware accelerators can include Fast Fourier Transform (FFT) circuits and encoder/decoder circuits. In some aspects, the processor and hardware accelerator components of digital signal processor 208 may be realized as a coupled integrated circuit.

Communication device 200 may be configured to operate according to one or more radio communication technologies. Digital signal processor 208 may be responsible for lower-layer processing functions (e.g., Layer 1/PHY) of the radio communication technologies, while protocol controller 210 may be responsible for upper-layer protocol stack functions (e.g., Data Link Layer/Layer 2 and/or Network Layer/Layer 3). Protocol controller 210 may thus be responsible for controlling the radio communication components of communication device 200 (antenna system 202, RF transceiver 204, and digital signal processor 208) in accordance with the communication protocols of each supported radio communication technology, and accordingly may represent the Access Stratum and Non-Access Stratum (NAS) (also encompassing Layer 2 and Layer 3) of each supported radio communication technology. Protocol controller 210 may be structurally embodied as a protocol processor configured to execute protocol stack software (retrieved from a controller memory) and subsequently control the radio communication components of communication device 200 to transmit and receive communication signals in accordance with the corresponding protocol stack control logic defined in the protocol software. Protocol controller 210 may include one or more processors configured to retrieve and execute program code that defines the upper-layer protocol stack logic for one or more radio communication technologies, which can include Data Link Layer/Layer 2 and Network Layer/Layer 3 functions. Protocol controller 210 may be configured to perform both user-plane and control-plane functions to facilitate the transfer of application layer data to and from radio communication device 200 according to the specific protocols of the supported radio communication technology. User-plane functions can include header compression and encapsulation, security, error checking and correction, channel multiplexing, scheduling and priority, while control-plane functions may include setup and maintenance of radio bearers. The program code retrieved and executed by protocol controller 210 may include executable instructions that define the logic of such functions.

Communication device 200 may also include application processor 212 and memory 214. Application processor 212 may be a CPU, and may be configured to handle the layers above the protocol stack, including the transport and application layers. Application processor 212 may be configured to execute various applications and/or programs of communication device 200 at an application layer of communication device 200, such as an operating system (OS), a user interface (UI) for supporting user interaction with communication device 200, and/or various user applications. The application processor may interface with baseband modem 206 and act as a source (in the transmit path) and a sink (in the receive path) for user data, such as voice data, audio-/video/image data, messaging data, application data, basic Internet/web access data, etc. In the transmit path, protocol controller 210 may therefore receive and process outgoing data provided by application processor 212 according to the layer-specific functions of the protocol stack, and provide the resulting data to digital signal processor 208. Digital signal processor 208 may then perform physical layer processing on the received data to produce digital baseband samples, which digital signal processor may provide to RF transceiver 204. RF transceiver 204 may then process the digital baseband samples to convert the digital baseband samples to analog RF signals, which RF transceiver 204 may wirelessly transmit via antenna system 202. In the receive path, RF transceiver 204 may receive analog RF signals from antenna system 202 and process the analog RF signals to obtain digital baseband samples. RF transceiver 204 may provide the digital baseband samples to digital signal processor 208, which may perform physical layer processing on the digital baseband samples. Digital signal processor 208 may then provide the resulting data to protocol controller 210, which may process the resulting data according to the layer-specific functions of the protocol stack and provide the resulting incoming data to application processor 212. Application processor 212 may then handle the incoming data at the application layer, which can include execution of one or more application programs with the data and/or presentation of the data to a user via a user interface.

Memory 214 may embody a memory component of communication device 200, such as a hard drive or another such permanent memory device. Although not explicitly depicted in FIG. 2, the various other components of communication device 200 shown in FIG. 2 may additionally each include integrated permanent and non-permanent memory components, such as for storing software program code, buffering data, etc.

In accordance with some radio communication networks, terminal devices 102 and 104 may execute mobility procedures to connect to, disconnect from, and switch between available network access nodes of the radio access network of radio communication network 100. As each network access node of radio communication network 100 may have a specific coverage area, terminal devices 102 and 104 may be configured to select and re-select \ available network access nodes in order to maintain a strong radio access connection with the radio access network of radio communication network 100. For example, terminal device 102 may establish a radio access connection with network access node 110 while terminal device 104 may establish a radio access connection with network access node 112. In the event that the current radio access connection degrades, terminal devices 102 or 104 may seek a new radio access connection with another network access node of radio communication network 100; for example, terminal device 104 may move from the coverage area of network access node 112 into the coverage area of network access node 110. As a result, the radio access connection with network access node 112 may degrade, which terminal device 104 may detect via radio measurements such as signal strength or signal quality measurements of network access node 112. Depending on the mobility procedures defined in the appropriate network protocols for radio communication network 100, terminal device 104 may seek a new radio access connection (which may be, for example, triggered at terminal device 104 or by the radio access network), such as by performing radio measurements on neighboring network access nodes to determine whether any neighboring network access nodes can provide a suitable radio access connection. As terminal device 104 may have moved into the coverage area of network access node 110, terminal device 104 may identify network access node 110 (which may be selected by terminal device 104 or selected by the radio access network) and transfer to a new radio access connection with network access node 110. Such mobility procedures, including radio measurements, cell selection/reselection, and handover are established in the various network protocols and may be employed by terminal devices and the radio access network in order to maintain strong radio access connections between each terminal device and the radio access network across any number of different radio access network scenarios.

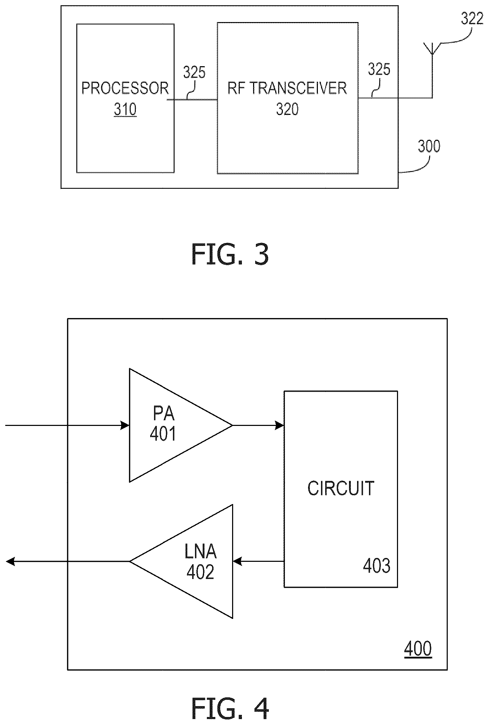

FIG. 3 shows an exemplary illustration of various communication elements of an apparatus for a wireless communication device (e.g. the communication device 200). The apparatus 300 may include processing circuitry 310 (e.g. the baseband modem 206, the application processor 212) that may direct and manage communication operations of the apparatus 300 according to one or more radio communication protocols, and may control transmission/reception of communication signals over at least one or more antenna 322 via an RF transceiver 320. The processing circuitry 310 may include an interface to the RF transceiver 320. The RF transceiver 320 may include at least one RF-chain to process the communication signals associated with the antenna 322 respectively. The apparatus 300 may include the antenna 322, or the apparatus 300 may include an antenna interface couplable to the antenna 322. It is to be noted that the apparatus 300 is depicted as being couplable to the antenna 322, but the apparatus 300 may be couplable to a plurality of antennas, and thereby the RF transceiver 320 may include a plurality of RF-chains, each RF-chain may process communication signals for a respective antenna. The apparatus 300 may transmit and receive radio communication signals with the antenna 322. The apparatus 300 may act as an RF transmitter (e.g. RF transmit circuit) to transmit radio communication signals and it may also act as an RF receiver (e.g. RF receive circuit) to receive radio communication signals. In accordance with various aspects described herein, amplifiers referred to in accordance with aspects described in FIG. 3 (e.g. PAs) may include aspects described in this disclosure, e.g. one or more amplifier circuitries.

The processing circuitry 310 may include, or may be implemented, partially or entirely, by circuit and/or logic, e.g., a processor including circuit and/or logic, a memory circuit and/or a logic, which may be configured to manage radio communication operations. The processing circuitry 310 may be configured to communicate with an external main processor (e.g. a host processor, a central processing unit (CPU), a system on chip (SoC)) of the wireless communication device including the apparatus 300 via a designated interface that is coupled to the main processor. In some examples, the processing circuitry 310 may be the main processor of the wireless communication device. The processing circuitry 310 may also access the main memory of the respective wireless communication device via the designated interface. The processing circuitry 310 may further include an interface to the RF transceiver 320.

The processing circuitry 310 may include a digital signal processor (e.g. the digital signal processor 208). The digital signal processor 208 may be configured to perform one or more of error detection, forward error correction encoding/decoding, channel coding, and interleaving, channel modulation/demodulation, physical channel mapping, radio measurement and search, frequency and time synchronization, antenna diversity processing, power control, and weighting, rate matching/dematching, retransmission processing, interference cancelation, and any other physical layer processing functions.

The processing circuitry 310 may include a modem configured to process baseband signals received from/sent to the antenna 322 via a communication path 325 including a respective RF-chain. In various examples, the interface to the RF transceiver 320 of the processing circuitry 310 may be configured to couple the processing circuitry 310 to the communication path 325. Accordingly, the processing circuitry 310 may include Media-Access Control (MAC) circuit and/or logic, Physical Layer (PHY) circuit and/or logic, baseband (BB) circuit and/or logic, a BB processor, a BB memory, Application Processor (AP) circuit and/or logic, an AP processor, an AP memory, and/or any other circuit and/or logic. By way of example, the processing circuitry 310 can perform baseband processing on the digital baseband signals to recover data included in wireless data transmissions.

The processing circuitry 310 may control and/or arbitrate transmit and/or receive functions of the apparatus 300, and perform one or more baseband processing functions (e.g., media access control (MAC), encoding/decoding, modulation/demodulation, data symbol mapping, error correction, etc.). The processing circuitry 310 may be configured to provide control functions to the RF transceiver 320 (e.g. to the RF-chain to control and/or arbitrate transmitting and/or receiving radio communication signals). In aspects, functions of processing circuitry 310 can be implemented in software and/or firmware executing on one or more suitable programmable processors, and may be implemented, for example, in a field programmable gate array (FPGA), application specific integrated circuit (ASIC), etc. In various examples, the interface to the RF transceiver 320 of the processing circuitry 310 may be configured to couple processing circuitry to the RF transceiver to provide communication in-between.

The RF transceiver 320 may provide RF processing of communication signals conveyed via a communication path within a respective RF-chain to transmit radio communication signals via a respective antenna based on signals (e.g. baseband communication signals, digital signals) received from the processing circuitry 310 over the communication path. The RF transceiver 320 may provide RF processing of communication signals conveyed via the communication path 325 to receive radio communication signals via the antenna 322 and provide signals to the processing circuitry 310 over the communication path 325. The processing circuity 310 may be configured to control operations of the RF transceiver 320. The RF transceiver 320 may include a receive path to provide RF processing to receive radio communication signals received from the antenna 322, and a transmit path to provide RF processing to transmit radio communication signals transmitted via the antenna 322.

In a receive (RX) path, The RF transceiver 320 may receive analog radio frequency signals from the antenna 322 via the communication paths 325 and perform analog and digital RF front-end processing on the analog radio frequency signals to produce digital baseband samples (e.g., In-Phase/Quadrature (IQ) samples) to provide to the processing circuitry 310. In various examples, RF transceiver 320 may include two RF-chains per antenna element, each RF-chain may be designated for a particular polarization. The RF transceiver 320 may include analog and digital reception components including amplifiers (e.g., Low Noise Amplifiers (LNAs)), filters, RF demodulators (e.g., RF IQ demodulators)), and analog-to-digital converters (ADCs), which RF transceiver 320 may utilize to convert the received radio frequency signals to digital baseband samples.

In a transmit (TX) path, the RF transceiver 320 may receive digital baseband samples from processing circuitry 310 and perform analog and digital RF front-end processing on the digital baseband samples to produce analog radio frequency signals to be provided to the antenna 322 via the communication paths 325 for radio transmission. The RF transceiver 320 may thus include analog and digital transmission components including amplifiers (e.g., Power Amplifiers (PAs), filters, RF modulators (e.g., RF IQ modulators), and digital-to-analog converters (DACs), which the RF transceiver 320 may utilize to mix the digital baseband samples received from processing circuitry 310 and produce respective analog radio frequency signals for radio transmission by the antenna 322. In some aspects, the processing circuitry 310 may control the radio transmission and reception of the RF transceiver 320, including specifying the transmit and receive radio frequencies for the operation of the RF transceiver 320. In some examples, the RF transceiver 320 may include a DTX architecture. In some examples, operations associated with the digital front-end may be provided by the processing circuitry 310 as well, or in other words, the processing circuitry 310 may include the digital front-end.

FIG. 4 shows schematically a block diagram of an example radio frequency (RF) front end circuit 400 that may be implemented in a radio communication device including a transmitter and a receiver, which an RF-chain of an RF transceiver (e.g. the RF transceiver 320) may include. A TX path of the radio frequency (RF) front end circuit 400 may include a PA 401 for amplifying input radio frequency (RF) signals. The RF front end circuit 400 may further include an RX path. The RX path of the radio frequency (RF) front end circuit 400 may include an LNA 402 to amplify received radio frequency (RF) signals and provides the amplified received radio frequency (RF) signals as an output. One or more filters may be included to generate suitable radio frequency (RF) signals for transmission and reception. In addition, the radio frequency (RF) front end circuit 400 may include other components or circuits 403, such as, for example, a tuner or a matching network, switches, multiplexers, and/or other circuits for coupling the radio frequency (RF) front end circuit 400 to an antenna, in order to form an RF transceiver. In addition, other components may be included to support both transmit and receive functions. In accordance with various aspects described herein, amplifiers referred to in accordance with aspects described in FIG. 4 (e.g. PAs) may include aspects described in this disclosure, e.g. one or more amplifier circuitries.

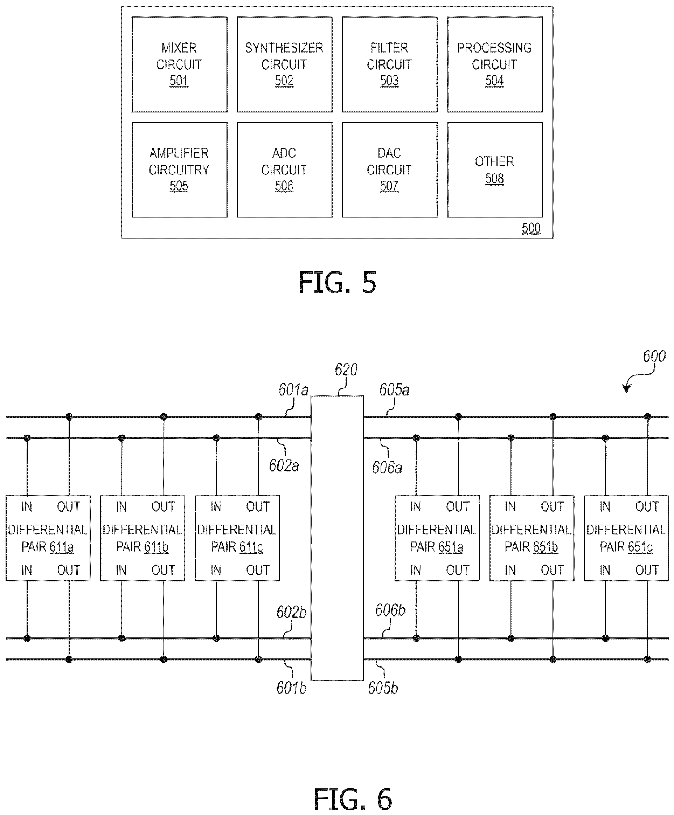

FIG. 5 shows schematically an example of a RF transceiver circuitry 500 which a radio communication device may include. The RF transceiver circuitry 500 can include components such as a mixer circuit 501, a synthesizer circuit 502 (e.g., local oscillator), a filter circuit 503 (e.g., baseband filter), a processing circuit 504, an amplifier circuitry 505, an analog-to-digital converter (ADC) circuit 506, a digital-to-analog (DAC) circuit 507, and other suitable digital front end (DFE) components 508, to name a few. The processing circuit 504 may include a processor, which may include a time-domain and/or frequency domain processor(s)/components in at least one example.

Accordingly, the exemplary radio frequency (RF) front end circuit 400 referred with respect to FIG. 4 may be provided by a combination of the circuits provided with respect to the schematic representation of the example of the RF transceiver circuitry 500. It should be noted that any of these circuits may include a plurality of circuits configured to provide the functionality. For example, the amplifier circuitry 505 may include a plurality of amplifier circuits or amplifiers as described in this disclosure.

The other components 508 may include logic components, modulation/demodulation elements, and an interface circuit for interfacing with another component, e.g., an SoC, or a modem. Digital front end components may include any suitable number and/or type of components configured to perform functions known to be associated with digital front ends.

The digital front end may include digital processing circuit, portions of processing circuitry, one or more portions of an on-board chip having dedicated digital front end functionality (e.g., a digital signal processor), etc. The digital front end components may selectively perform specific functions based upon the operating mode of the RF transceiver circuitry 500. The digital front end components may facilitate beamforming.

Digital front end components may also include other components associated with data transmission such as, for instance, transmitter impairment correction such as LO correction, DC offset correction, IQ imbalance correction, and ADC skew, digital pre-distortion (DPD) calculation, correction factor (CF) calculation, and pre-emphasis (pre. emp.) calculation. To provide additional examples, the digital front end components may facilitate or perform receiver or transmitter digital gain control (DGC), up-sampling, down-sampling, zero crossing detection algorithms, phase modulation, perform beam management, digital blocker cancellation, received signal strength indicator (RSSI) measurements, DPD and calibration accelerators, test signal generation, etc.

The RF transceiver circuitry 500 may include a receive signal path which may include the mixer circuit 501, the amplifier circuitry 505, and the filter circuit 503. In some aspects, the transmit signal path of the RF transceiver circuitry 500 may include the filter circuit 503, the amplifier circuitry 505, and the mixer circuit 501. The radio communication circuit may also include the synthesizer circuit 502 to synthesize a frequency signal for use by the mixer circuit 501 of the receive signal path and the transmit signal path. The mixer circuit 501 of the receive signal path may be configured to down-convert radio frequency (RF) signals received based on the synthesized frequency provided by synthesizer circuit 502.

In some aspects, the output baseband signals and the input baseband signals may be digital baseband signals. In such aspects, the RF transceiver circuitry 500 may include the analog-to-digital converter (ADC) circuit 506 and the digital-to-analog converter (DAC) circuit 507.

The RF transceiver circuitry 500 may also include a transmit signal path (Tx path) which may include a circuit to up-convert baseband signals provided by a modem and provide radio frequency (RF) output signals for transmission. In some aspects, the receive signal path of the RF transceiver circuitry 500 may include the mixer circuit 501, the amplifier circuitry 505, and the filter circuit 503. In some aspects, the transmit signal path of the RF transceiver circuitry 500 may include the filter circuit 503, the amplifier circuitry 505, and the mixer circuit 501. The RF transceiver circuitry 500 may include synthesizer circuit 502 to synthesize a frequency signal for use by the mixer circuit 501 of the receive signal path and the transmit signal path. The mixer circuit 501 of the receive signal path may be configured to received down-convert radio frequency (RF) signals based on the synthesized frequency provided by synthesizer circuit 502.

Amplifier circuitry 505 may be configured to amplify the down-converted signals, and filter circuit 503 may be a low-pass filter (LPF) or band-pass filter (BPF) configured to remove unwanted signals from the down-converted signals to generate output baseband signals. Output baseband signals may be provided to another component, e.g., a modem, for further processing. In some aspects, the output baseband signals may be zero-frequency baseband signals, although this is not a requirement. In accordance with various aspects described herein, amplifier circuitry 505 may be an amplifier circuitry and may include aspects described in this disclosure. Illustratively, the amplifier circuitry may include one or more NDP arrays as PAs.

The mixer circuit 501 for a receive signal path may include passive mixers, although the scope of this disclosure is not limited in this respect. In some aspects, the mixer circuit 501 for a transmit signal path may be configured to up-convert input baseband signals based on the synthesized frequency provided by the synthesizer circuit 502 to generate radio frequency (RF) output signals. In various aspects, amplifier circuitry 505 may be configured to amplify the radio frequency (RF) output signals, and filter circuit 503 may be a low-pass filter (LPF) or band-pass filter (BPF) configured to remove unwanted signals from the up-converted signals to provide communication signals to be transmitted. The radio frequency (RF) communication signals may be provided to another component, to an antenna port or an antenna.

In some aspects, the mixer circuit 501 of the receive signal path and the mixer circuit 501 of the transmit signal path may include two or more mixers and may be arranged for quadrature down conversion and up conversion, respectively. In some aspects, the mixer circuit 501 of the receive signal path and the mixer circuit 501 of the transmit signal path may include two or more mixers and may be arranged for image rejection (e.g., Hartley image rejection). In some aspects, the mixer circuit 501 of the receive signal path and the mixer circuit 501 may be arranged for direct down conversion and direct up conversion, respectively. In some aspects, the mixer circuit 501 of the receive signal path and the mixer circuit 501 of the transmit signal path may be configured for super-heterodyne operation.

In some dual-mode aspects, a separate radio IC circuit may be provided for processing signals for each spectrum, although the scope of this disclosure is not limited in this respect.

In some aspects, the synthesizer circuit 502 may be a fractional-N synthesizer or a fractional N/N+1 synthesizer, although the scope of the aspects is not limited in this respect as other types of frequency synthesizers may be suitable. For example, synthesizer circuit 502 may be a delta-sigma synthesizer, a frequency multiplier, or a synthesizer including a phase-locked loop with a frequency divider.

The synthesizer circuit 502 may be configured to synthesize an output frequency for use by the mixer circuit 501 of the RF transceiver circuitry 500 based on a frequency input and a divider control input. The synthesizer circuit 502 may be a fractional N/N+1 synthesizer.

Frequency input may be provided by a voltage-controlled oscillator (VCO), although that is not a requirement. Divider control input may be provided by a processing component of the RF transceiver circuitry 500 or may be provided by any suitable component, such as an external component like a modem. For example, the modem may provide a divider control input depending on the desired output frequency. A divider control input (e.g., N) may be determined from a look-up table based on a channel indicated by an external component.

Synthesizer circuit 502 of the RF transceiver circuitry 500 may include a divider, a delay-locked loop (DLL), a multiplexer, and a phase accumulator. The divider may be a dual modulus divider (DMD) and the phase accumulator may be a digital phase accumulator. The DMD may be configured to divide the input signal by either N or N+1 (e.g., based on a carry out) to provide a fractional division ratio. The DLL may include a set of cascaded, tunable, delay elements, a phase detector, a charge pump, and a D-type flip-flop. The delay elements may be configured to break a VCO period up into No equal packets of phase, where Nd is the number of delay elements in the delay line. In this way, the DLL provides negative feedback to help ensure that the total delay through the delay line is one VCO cycle.

Synthesizer circuit 502 may be configured to generate a carrier frequency as the output frequency, while in an alternative, the output frequency may be a multiple of the carrier frequency (e.g., twice the carrier frequency, four times the carrier frequency) and used in conjunction with quadrature generator and divider circuit to generate multiple signals at the carrier frequency with multiple different phases with respect to each other. The output frequency may be a LO frequency (fLO). In some aspects, the RF transceiver circuitry 500 may include an IQ/polar converter.

While the RF transceiver circuitry 500 described herein include traditional super-heterodyning schemes or architectures, other types of transceiver or transmitter architectures and schemes may be used. The RF transceiver circuitry 500 may include components to implement a near zero IF scheme, a Direct Conversion scheme, or a digital transmission scheme, such as, for example, a Digital IQ transmission, a Digital Polar transmission, and the like.

The RF transceiver circuitry 500 may include a transmit path that includes or implements a direct digital transmitter (DDT). That is, a DDT may include a digital signal processor, an RF digital-to-analog converter (RFDAC), an RF filter/antenna coupler. Further, a DDT may be implemented with or without an IQ-mixer. In general, an RF-DAC may be included on an RFIC to convert digital input into an RF signal. A DDT may include other digital components such as numerically controlled oscillator (NCO) and digital mixers for shifting an input signal to the desired frequency. The use of a DDT can reduce the number of analog components needed in the transmitter or transmit path. For example, analog LOs, analog filters, analog mixers, and etc., may be eliminated from the RFIC when a direct digital transmitter such as DDT is employed. Further, the use of a digital transmitter or digital transmission schemes may bring energy savings and efficiencies.

FIG. 6 shows schematically an example of an amplifier circuitry in accordance with various aspects provided herein. The amplifier circuitry 600 may include a plurality of differential amplifiers 61 1a-c, 651a-c, each differential amplifier including a circuit including pair of amplifiers configured in a differential configuration (which may be referred to as a differential pair amplifier). The amplifier circuitry 600 may include supply lines and ground lines to supply differential input signals to the plurality of differential pair amplifiers 61 1a-c, 651a-c (i.e. input connections) and to supply output signals of the plurality of differential pair amplifiers 611a-c, 651a-c to one or more output terminals of the amplifier circuitry 600.

As illustrated in this example, the amplifier circuitry 600 may include first differential input connections 602a-b configured to supply differential input signals received by the amplifier circuitry 600 to first differential pair amplifiers 61 1a-c. Illustratively, first active device (e.g. transistor) of each differential pair amplifier 611a-c may receive a first input signal from one of the first differential input connections 602a-b and second active device (e.g. transistor) of each differential pair amplifier 61 1a-c may receive a second input signal, that is a differential pair of the first input signal, from another one of the first differential input connections 602a-b.

Illustratively, the first differential input connections 602a-b may include a positive input connection and a negative input connection. Positive input terminals of the first differential pair amplifiers 611a-c may be coupled to the positive input connection and negative input terminals of the first differential pair amplifiers 611a-c may be coupled to the negative input connection. Similarly, the second differential input connections 606a-b may include a positive input connection and a negative input connection. Positive input terminals of the second differential pair amplifiers 651a-c may be coupled to the positive input connection and negative input terminals of the second differential pair amplifiers 65 1a-c may be coupled to the negative input connection.

Further, the amplifier circuitry 600 may include second differential input connections 606a-b configured to supply differential input signals received by the amplifier circuitry 600 to second differential pair amplifiers 651a-c. Illustratively, first active device (e.g. transistor) of each differential pair amplifier 65 1a-c may receive a first input signal from one of the second differential input connections 606a-b and second active device (e.g. transistor) of each differential pair amplifier 651a-c may receive a second input signal, that is a differential pair of the first input signal, from another one of the second differential input connections 602a-b.

In some aspects, the first input signal described with respect to the second differential pair amplifiers 651a-c may be the first input signal described with respect to the first differential pair amplifiers 61 1a-c. Similarly, the second input signal described with respect to the second differential pair amplifiers 65 1a-c may be the second input signal described with respect to the first differential pair amplifiers 61 1a-c.

Furthermore, the amplifier circuitry 600 may include first differential output connections 601a-b configured to supply differential output signals received from the first differential pair amplifiers 611a-c to an output terminal. Illustratively, first active device (e.g. transistor) of each differential pair amplifier 61 1a-c may output a first output signal to one of the first differential output connections 601a-b and second active device (e.g. transistor) of each differential pair amplifier 611a-c may output a second output signal, that is a differential pair of the first output signal, from another one of the first differential output connections 601a-b.

Moreover, the amplifier circuitry 600 may include second differential output connections 605a-b configured to supply differential output signals received from the second differential pair amplifiers 651a-c to an output terminal. Illustratively, first active device (e.g. transistor) of each differential pair amplifier 651a-c may output a first output signal to one of the second differential output connections 605a-b and second active device (e.g. transistor) of each differential pair amplifier 651a-c may output a second output signal, that is a differential pair of the first output signal, from another one of the second differential output connections 605a-b.

In accordance with various aspects provided herein, the plurality of differential pair amplifiers 61 1a-c, 651a-c may be considered as an array. In this representation, the first differential pair amplifiers 611a-c may be referred to as a first sub-array of the amplifier circuitry 600 and the second differential pair amplifiers 65 1a-c may be referred to as a second sub-array of the amplifier circuitry 600. These representations may be used throughout this disclosure to simply refer to respective differential pair amplifiers as described herein.

The first differential pair amplifiers 611a-c may be coupled to (i.e. between) the first differential output connections 601a-b and the first differential input connections 602a-b. Illustratively, the first differential output connections 601a-b may be disposed on a plane extending in one direction. The first differential input connections 602a-b may be disposed on the plane extending in the same direction, in a manner that is parallel or substantially parallel to the first differential output connections 601a-b, between the first differential output connections 601a-b. The first differential pair amplifiers 611a-c may also be disposed on the plane extending the same direction, in a manner that is parallel or substantially parallel to the first differential output connections 601a-b and/or the first differential input connections 602a-b, between the first differential output connections 601a-b and the first differential input connections 602a-b.

Similarly, the second differential pair amplifiers 651a-c may be coupled between the second differential output connections 605a-b and the second differential input connections 606a-b. Illustratively, the second differential output connections 605a-b may be disposed on a plane extending in one direction. The second differential input connections 606a-b may be disposed on the plane extending in the same direction, in a manner that is parallel or substantially parallel to the second differential output connections 605a-b, between the second differential output connections 605a-b. The second differential pair amplifiers 651a-c may also be disposed on the plane extending the same direction, in a manner that is parallel or substantially parallel to the second differential output connections 605a-b and/or the second differential input connections 606a-b, between the second differential output connections 605a-b and the second differential input connections 606a-b.

Due to their potential deployment within close proximity, and their possible parallel (or substantially parallel) placement, in particular considering high frequencies of mmWave - subTHz signals, a considerable magnetic and electric coupling may occur between input and output connections within close proximity. In this illustration, a first output connection 601a of the first differential output connections is provided within close proximity to a first input connection 602a of the first differential input connections. Similarly, a second output connection 601b of the first differential output connections is provided within close proximity to a second input connection 602b of the first differential output connections. Through the magnetic coupling associated with the first differential input connections 602a-b and the first differential output connections 601a-b (i.e. magnetic coupling between the first differential input connections 602a-b and the first differential output connections 601a-b), first magnetic feedback currents may be generated within the amplifier circuitry 600.

Further, a first output connection 605a of the second differential output connections is provided within close proximity to a first input connection 606a of the second differential input connections. Similarly, a second output connection 605b of the second differential output connections is provided within close proximity to a second input connection 606b of the second differential output connections. Through the magnetic coupling associated with the second differential input connections 606a-b and the second differential output connections 605a-b (i.e. magnetic coupling between the second differential input connections 606a-b and the second differential output connections 605a-b), second magnetic feedback currents may be generated within the amplifier circuitry 600.

The amplifier circuitry may further include a connector 620. The connector 620 may include conductors, such as wires, traces, vias, etc. to provide connections. The connector 620 may couple the first differential pair amplifiers 61 1a-c and the second differential pair amplifiers 651a-c for operation of the amplifier circuitry 600. Illustratively, in a parallel configuration, the differential pair amplifiers 61 1a-c, 651a-c are coupled to input and output connections 601a-b, 602a-b, 605a-b, 606a-b to form a chain. The connector 620 may couple the first differential input and output connections 601a-b, 602a-b and the second differential input and output connections 605a-b, 606a-b, and inherently the first differential pair amplifiers 611a-c, and the second differential pair amplifiers 651a-c, such that each differential pair amplifier receives the differential input signals and provides its respective output signal based on the received differential input signals.

In accordance with various aspects provided herein, the connector 620 may particularly couple the first differential input connections 602a-b and the second differential input connections 606a-b in a manner, such that magnetic feedback currents associated with the magnetic coupling between the first differential input connections 602a-b and the first differential output connections 601a-b and magnetic feedback currents associated with the magnetic coupling between the second differential input connections 606a-b and the second differential output connections 605a-b may mitigate (e.g. cancel out, at least partially), each other.

In accordance with various aspects provided herein, the connector 620 may particularly couple the first differential output connections 601a-b and the second differential output connections 605a-b in a manner, such that magnetic feedback currents associated with the magnetic coupling between the first differential output connections 601a-b and the first differential input connections 602a-b, and magnetic feedback currents associated with the magnetic coupling between the second differential output connections 605a-b and the second differential input connections 606a-b may mitigate (e.g. cancel out, at least partially), each other.

In accordance with various aspects provided herein, the connector 620 may couple the first differential input and output connections 601a-b, 602a-b and the second differential input and output connections 605a-b, 606a-b, such that a first magnetic coupling coefficient associated with the first magnetic coupling that is between the first differential output connections 601a-b and the first differential input connections 602a-b and a second magnetic coupling coefficient associated with the second magnetic coupling that is between the second differential output connections 605a-b and the second differential input connections 606a-b have opposite polarities. Namely, if the first magnetic coupling coefficient is positive, the second magnetic coupling coefficient is negative. Alternatively, if the first magnetic coupling coefficient is negative, the second magnetic coupling coefficient is positive.

A magnetic coupling coefficient may refer to a measure of magnetic coupling between two conductors or components. The magnetic coupling coefficient may have a magnitude (e.g. between 0 and 1), representing the strength of the magnetic coupling, and a polarity (i.e. a positive or negative sign) that is indicative of the polarity or direction of the induced currents or the phase relationship between the two conductors or components. Illustratively, a higher magnitude coupling coefficient indicates a stronger magnetic interaction between the two conductors or components, while the polarity may indicate the direction of the generated (i.e. induced) currents. In accordance with various aspects described herein, the connector 620 may couple the first differential input and output connections 601a-b, 602a-b and the second differential input and output connections 605a-b, 606a-b, such that the generated magnetic feedback currents associated with the first and second magnetic coupling are at opposite directions.

The skilled person would appreciate that, the amplifier circuitry 600 may have identical structures throughout the circuitry, which may include the use of identical materials for the first and second differential input connections 602a-b, 606a-b, and/or for the first and second differential output connections 601a-b, 605a-b. In this configuration, noting that the first and second differential connections may be disposed at substantially the same length, which may result in substantially same magnetic coupling coefficient magnitudes for the first magnetic coupling and the second magnetic coupling to maximize cancelling out of magnetic feedback currents (i.e. minimize the effect of magnetic coupling associated with input and output connections). In other words, in some examples, the magnitude of the first magnetic coupling coefficient and the magnitude of the second magnetic coupling coefficient are equal or substantially equal.

It is further to be considered that, although the precision for minimizing the effect of above-mentioned magnetic coupling may be desirable, in some examples, identical structures and/or the precision to minimize the above-mentioned effect may not be desired, and instead the aspects provided in this disclosure may merely be employed to reduce the effect of magnetic coupling associated with input and output connections. This may even be provided in a manner that a designer may design the amplifier circuitry with an effect of magnetic coupling associated with input and output connections that is acceptable, illustratively through simulation and experimentation via use of non-identical structures and designs.

The connector 620 may provide the above-mentioned coupling to cancel out magnetic feedback currents (or provide magnetic coupling coefficients having opposite polarities) in various manners. Noting that actual contribution to a magnetic coupling between input and output connections arises from the connections disposed on the plane in a close proximity (i.e. closer than other connection combinations), the connector 620 may couple the first differential input and output connections 601a-b, 602a-b and the second differential input and output connections 605a-b, 606a-b, such that close-proximity input and output connections associated with one of the first differential pair amplifiers 61 1a-c or the second differential pair amplifiers 651a-c have opposite polarities while close-proximity input and output connections associated with other one of the first differential pair amplifiers 61 1a-c or the second differential pair amplifiers 651a-c have the same polarities.

Illustratively, the first output connection 601a of the first differential output connections and the first input connection 602a of the first differential input connections are first close-proximity connections for the first differential pair amplifiers 61 1a-c. Similarly, the second output connection 601b of the first differential output connections and the second input connection 602b of the first differential input connections are second close-proximity connections for the first differential pair amplifiers 61 1a-c.

Illustratively, the first output connection 605a of the second differential output connections and the first input connection 606a of the second differential input connections are first close-proximity connections for the second differential pair amplifiers 651a-c. Similarly, the second output connection 605b of the second differential output connections and the second input connection 606b of the second differential input connections are second close-proximity connections for the first differential pair amplifiers 61 1a-c.

Accordingly, in one example, the first close proximity connections for the first differential pair amplifiers 611a-c may have opposite polarities in between and the second close proximity connections for the first differential pair amplifiers 611a-c may also have opposite polarities in between, while the first close-proximity connections for the first differential pair amplifiers 611a-c may have the same polarities in between and the second close-proximity connections for the first differential pair amplifiers 611a-c may have the same polarities in between.

Illustratively, close proximity connections having opposite polarities may include one input connection and one output connection such that, i) when the input connection is coupled to positive input terminals of the first differential pair amplifiers 61 1a-c, the output connection is coupled to negative output terminals of the first differential pair amplifiers 61 1a-c; or ii) when the input connection is coupled to negative input terminals of the first differential pair amplifiers 61 1a-c, the output connection is coupled to positive output terminals of the first differential pair amplifiers 61 1a-c.

Alternatively, in one example, the first close proximity connections for the first differential pair amplifiers 611a-c may have the same polarities in between and the second close proximity connections for the first differential pair amplifiers 611a-c may also have the same polarities in between, while the first close-proximity connections for the first differential pair amplifiers 611a-c may have the opposite polarities in between and the second close-proximity connections for the first differential pair amplifiers 611a-c may have the opposite polarities in between.

Illustratively, close proximity connections having the same polarities may include one input connection and one output connection such that, i) when the input connection is coupled to positive input terminals of the first differential pair amplifiers 61 1a-c, the output connection is coupled to positive output terminals of the first differential pair amplifiers 61 1a-c; or ii) when the input connection is coupled to negative input terminals of the first differential pair amplifiers 61 1a-c, the output connection is coupled to negative output terminals of the first differential pair amplifiers 611a-c.

In the context of differential pair amplifiers, the above-mentioned close-proximity connections having the opposite polarities may refer to that both the respective input connection of the close proximity connections and the respective output connection of the close proximity connections are provided to carry signals for the same active device of a differential pair. Illustratively, in this constellation, a first active device of a differential pair amplifier may receive its input signal from the respective input connection of the close proximity connections and may provide its output to the respective output connection of the close proximity connections. In other words, their magnetic coupling coefficients have the opposite polarities.

In the context of differential pair amplifiers, the above-mentioned close-proximity connections having the same polarities may refer to that both the respective input connection of the close proximity connections and the respective output connection of the close proximity connections are provided to carry signals for different active devices of a differential pair. Illustratively, in this constellation, a first active device of a differential pair amplifier may receive its input signal from the respective input connection of the close proximity connections and a second active device of a differential pair amplifier may provide its output to the respective output connection of the close proximity connections. In other words, magnetic coupling coefficients have the same polarities.

Accordingly, the connector 620 may be configured to couple the first input connection 601a of the first differential input connections to the second input connection 606b of the second differential input connections and couple the second input connection 602b of the first differential input connections to the first input connection 606a of the second differential input connections. In one example, the connector 620 may further couple the first output connection 601a of the first differential output connections to the first output connection 605a of the second differential output connections. The connector 620 may further couple the second output connection 601b of the first differential output connections to the second output connection 605b of the second differential output connections. In one example, the first output connection 601a of the first differential output connections and the first output connection 605a of the second differential output connections may be a first interconnect (i.e. may form one single output connection), and the second output connection 601b of the first differential output connections and the second output connection 605b of the second differential output connections may be a second interconnect (i.e. may form other one single output connection). Accordingly, for the plurality of differential pair amplifiers, each having the substantially same physical layout, the above-mentioned aspect may be obtained.

Alternatively, the connector 620 may be configured to couple the first output connection 601a of the first differential output connections to the second output connection 605b of the second differential output connections and couple the second output connection 601b of the first differential output connections to the first output connection 605a of the second differential output connections. In one example, the connector 620 may further couple the first input connection 602a of the first differential input connections to the first input connection 606a of the second differential input connections. The connector 620 may further couple the second input connection 602b of the first differential input connections to the second input connection 606b of the second differential input connections. In one example, the first input connection 602a of the first differential input connections and the first input connection 606a of the second differential input connections may be a first interconnect (i.e. may form one single input connection), and the second input connection 602b of the first differential input connections and the second input connection 606b of the second differential input connections may be a second interconnect (i.e. may form other one single output connection). Accordingly, for the plurality of differential pair amplifiers, each having the substantially same physical layout, the above-mentioned aspect may be obtained.

Within the context of NDP arrays, an active core of a PA (e.g. mmWave PA) may include capacitively neutralized NDP cells as described herein through which an NDP array is formed for a larger active core to produce a large output power, which may be based on the number of differential pair amplifiers used within the NDP array.

Differential pair amplifiers may include neutralizing capacitors, which may be formed by interconnect parasitic or directly with active devices, to cancel the electric or capacitive feedback from output to input created by active device capacitance (e.g. drain-gate capacitance). This neutralization may be effective, in particular, when active devices are driven differentially, which may improve gain, stability factor, robustness to PVT.

In high power PA designs, higher output power may be achieved using a larger device size that is formed by arraying a unit cell sized NDP cell to form one or two dimensional physical array (1xN , 2xN,... NxN) in a designated layout. Depending upon operating frequency and size of the array, the distributed effects associated with parasitic inductance and mutual inductance on both input (gate) and output (drain) signal routing can be significant and may need a careful modeling using both electromagnetic and parasitic extraction tools. Traditionally, it is common for these inductive effects to be ignored for an NDP design but this may pose a significant design risk at mmWave and subTHz frequencies. Since each NDP unit cell may include a local neutralization canceling out electric feedback associated with gate-drain capacitance of active devices, the magnetic component of the feedback may become dominating effect for the degradation in stability and gain for a large NDP array. To ensure stability, the array size may be often limited to reduce the amount of magnetic feedback and but this results in a reduced output power.

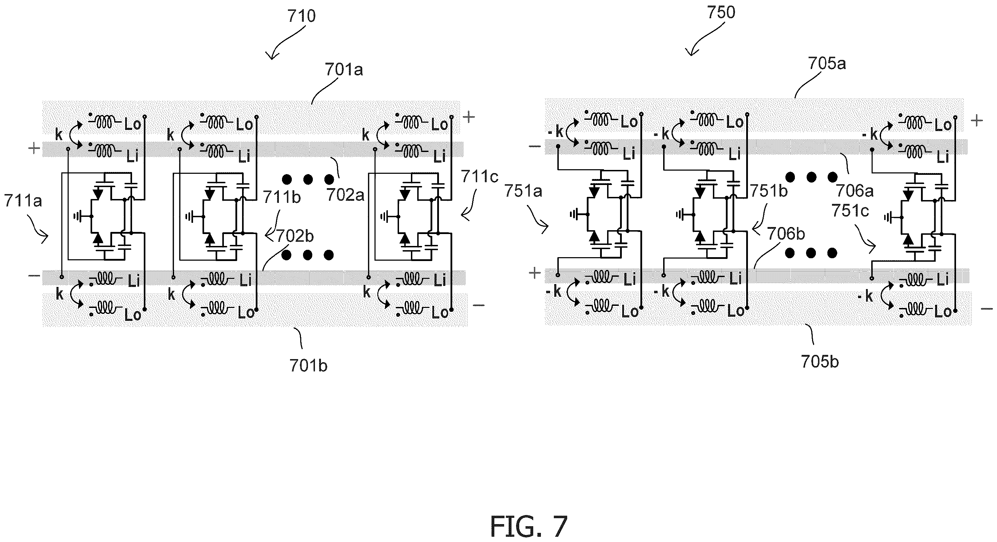

FIG. 7 shows schematically an exemplary illustration of two subarrays of an amplifier circuitry in accordance with various aspects of this disclosure. It is to be noted that various aspects described with respect to FIG. 6 apply to the amplifier circuitry described herein. In order to maintain links associated with the aspects, reference numbers associated with aspects described herein follow the same numbering formulation in accordance with aspects described in FIG. 6, in other words, similar reference numbers refer to similar parts and functions as described with respect to FIG. 6.

The amplifier circuitry may include an NDP array including a first subarray 710 and a second subarray 750. Each subarray 710, 750 may include N number of differential pair amplifiers (i.e. NDP unit cells). The first subarray 710 may include multiple first differential pair amplifiers including a first differential pair amplifier 711a, a second differential pair amplifier 711b, and a third differential pair amplifier 711c. The second subarray 750 may include multiple second differential pair amplifiers including a fourth differential pair amplifier 751a, a fifth differential pair amplifier 751b, and a sixth differential pair amplifier 751c. The amplifier circuitry may further include first differential input connections 702a-b and first differential output connections 701a-b between which the first differential pair amplifiers 711a-c are coupled to. The amplifier circuitry may further include second differential input connections 706a-b and second differential output connections 705a-b, between which the second differential pair amplifiers 751a-c are coupled to. As indicated, all aspects described for these components in FIG. 6 apply to components described in FIG. 7.

Each differential pair amplifier of the plurality of differential pair amplifiers 71 1a-c, 751a-c may have substantially the same layout, noting the difference associated with gate-drain connections of transistors as illustrated. As depicted herein, a differential pair amplifier may include a pair of active devices, depicted as transistors connected in a common-source configuration illustratively. In some examples, the transistors may be connected in a common-gate configuration. A gate of a first transistor of each pair may be coupled to one of the differential input connections 702a-b, 706a-b associated with the respective array to receive a respective input signal and a source of the first transistor may be coupled to one of the differential output connections 701a-b, 705a-b associated with the respective array. A gate of a second transistor of each pair may be coupled to another one of the differential input connections 702a-b, 706a-b associated with the respective array to receive a respective input signal and a source of the second transistor may be coupled to another one of the differential output connections 701a-b, 705a-b.

Furthermore, each differential pair amplifier may include at least one neutralizing component. In this illustration, at least one neutralizing component for each differential pair includes capacitors coupled to gate of the first transistor and the drain of the second transistor and to gate of the second transistor and the drain of the first transistor. The at least one neutralizing component is configured to neutralize the parasitic capacitance associated with the respective differential pair amplifier.

For each subarray, differential mode parasitic inductance per each length D of close proximity connections including a differential input connection and a differential output connection is shown as $L_i$ and $L_o$. Generally, within each length D, one of the differential pair amplifiers may be disposed between the respective differential input and output connections as depicted herein, and the mutual magnetic coupling between $L_i$ and $L_o$ within each length D is denoted as k, the magnetic coupling coefficient associated with the respective length D. In some examples, the magnetic coupling coefficient may also be associated with the respective differential pair amplifiers. In a scenario, which identically structured differential pair amplifiers implemented as NDP cells, each length D and their corresponding magnetic coupling coefficient k may be considered substantially the same. It is further to be noted that based on the relative position of input (e.g. gate) and output (e.g. drain) traces in the layout (i.e. common-source layout), the sign of the magnetic coupling could be either positive or negative, which may be referred to a positive differential input or output connection or a negative differential input or output connection respectively, as described also in FIG. 6.

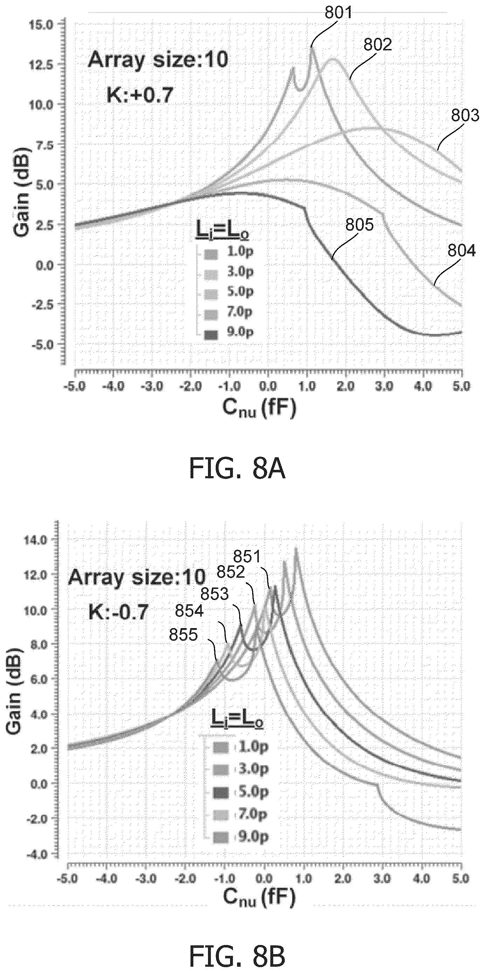

FIG. 8A and FIG. 8B show exemplary illustration of plots of maximum stable gain (MSG) or maximum available gain (MAG) vs. neutralization capacitor $C_{nu}$ for values of parasitic inductance $L_i$ and $L_o$ varying from 1 pH to 9 pH at the respective subarrays, when they are considered independent from each other.

Without loss of generality, simplified assumptions can be made such as with the input output parasitic inductance is made equal (i.e. Li=Lo) at each unit length D with the magnitude of mutual magnetic coupling K=0.7. As seen in the plots, it is immediately apparent that the magnitude of the parasitic inductance may impact the gain (and stability, not shown) for both variants of the NDP at 140GHz for the array size of 10.

801 and 851 illustrate the cases in which Li=Lo=1pH respectively. 802 and 852 illustrate the cases in which Li=Lo=3pH respectively. 803 and 853 illustrate the cases in which Li=Lo=5pH respectively. 804 and 854 illustrate the cases in which Li=Lo=7pH respectively. 805 and 855 illustrate the cases in which Li=Lo=9pH respectively.

The results show that the array with +ve coupling coefficient (K=+0.7) may be highly sensitive to Li/Lo and for Li=Lo>3pH the amplifier circuitry may not be stabilized for any value of $C_{nu}$ within each unit NDP cells (which may be indicated by the lack of the 'horn curve' shape that is seen for $L_i=L_o$=3pH). This may result in that array size is unusable at 140GHz if Li=Lo is greater than 1pH, and the array size must be limited to less than 10 (N < 10) to ensure stability and this may limit attainable output power.

For the -ve magnetic coupling variant (K=-0.7), although the array can be stabilized for different values of $C_{nu}$ (demonstrated by 'horn' curves being preserved across the sweep), the maximum available gain from the device reduces from 10.5dB to 6dB as Li/Lo increases, which may reduce amplifier efficiency.

Aspects described herein with respect to cancelling out or reducing residual magnetic feedback associated with disposed differential input and output connections may accordingly improve the stability of the array. The induced magnetic feedback current from the magnetic coupling may be cancelled if both NDP subarrays, as described in FIG. 7, are appropriately connected together, as illustratively described herein. Since the respective magnetic coupling coefficients may be opposite in sign, the induced feedback currents from each NDP variant may cancel each other.

Furthermore, if the relative spacing between the differential input and the output connections, in particular, between the close proximity connections, are substantially the same throughout an array including the first subarray 710 and the second subarray 750, the absolute value of the coupling coefficient may also be substantially identical, and the magnetic feedback may be canceled, or substantially reduced, if each subarray includes an equal number of NDP cells, which may be disposed in substantially identical layouts, noting the difference associated with input and output connections of each active device.

Illustratively, with proper cancellation of the magnetic feedback, metrics associated with the amplifier circuitry, such as stability, gain, reverse isolation and bandwidth may improve. For a given stability factor, the amplifier circuitry may include an array size that is higher than traditional NDP arraying methods, and thereby increase the output power of the amplifier.

Furthermore, aspects described herein may also improve matching network losses and increase bandwidth. Noting that the real parts of source and load impedance may be required for biconjugate matching related to stability factor of any two-port network may be expressed as $G_{s,opt} = \frac{|Y_{21}Y_{12}|}{2\mathbb{R}\{Y_{22}\}}\sqrt{k^2-1}$ and

$G_{L,opt} = \frac{|Y_{21}Y_{12}|}{2\mathbb{R}\{Y_{11}\}}\sqrt{k^2-1}$ respectively, where two port y parameters of the device are used, k represents stability factor and operator $\mathbb{R}$ represents real part of complex number.

As can be seen from the above expressions, the real part of biconjugate impedance may approach to zero, when the two port device is at the edge of an unconditional stability (K=1). Additionally, as stability factor increases further above 1 (i.e. device is more stable), the real part of the matching impedances may increase, thereby decreasing the Q-factor (Qin at input

defined as $\left(\frac{B_{s,opt}}{G_{s,opt}}\right)$ . Thus, a higher stability factor for a two port network may result in a lower Q-factor required for bi-conjugate matching. The lower Q-factor can reduce the insertion loss from the input/output matching network and is also desirable for high bandwidth circuit design. Hence, even for already stable designs, this technique can be employed to reduce matching network losses and extend bandwidth of the design.

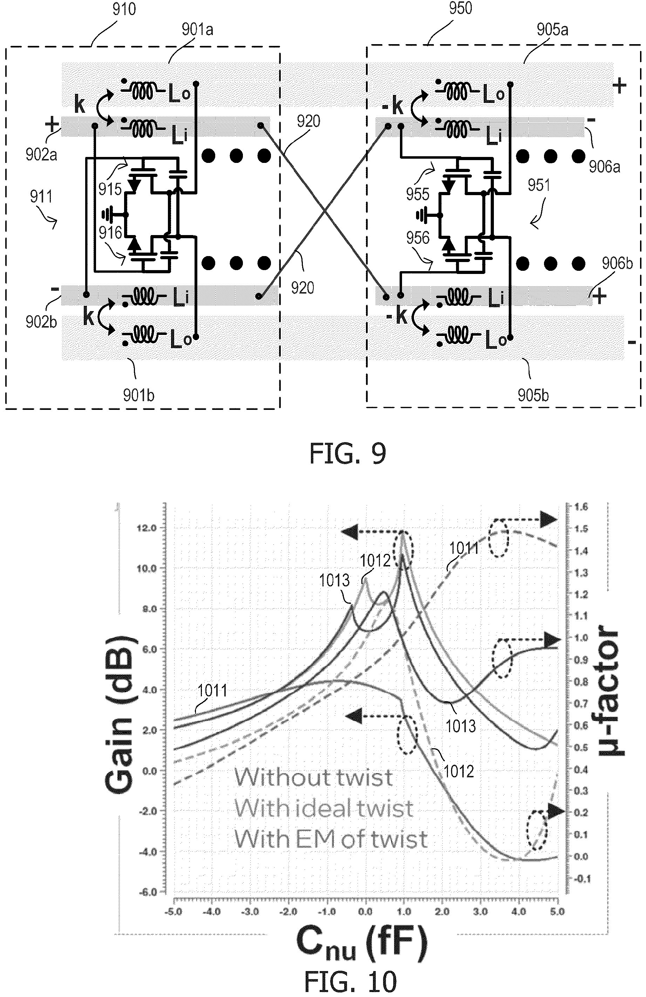

FIG. 9 shows schematically an exemplary illustration of two subarrays of an amplifier circuitry in accordance with various aspects of this disclosure. It is to be noted that various aspects described with respect to FIG. 6 and/or FIG. 7 apply to the amplifier circuitry described herein. In order to maintain links associated with the aspects, reference numbers associated with aspects described herein follow the same numbering formulation in accordance with aspects described in FIG. 6 and/or FIG. 7, in other words, similar reference numbers refer to similar parts and functions as described with respect to FIG. 6 and/or FIG. 7.

The amplifier circuitry may include an NDP array including a first subarray 910 and a second subarray 950. Each subarray 910, 950 may include N number of differential pair amplifiers (i.e. NDP unit cells). The first subarray 910 may include multiple first differential pair amplifiers 911. The second subarray 950 may include multiple second differential pair amplifiers including second differential pair amplifiers 951. The first subarray 910 may further include first differential input connections 902a-b and first differential output connections 901a-b between which the first differential pair amplifiers 911 are coupled to. The second subarray 950 may further include second differential input connections 906a-b and second differential output connections 905a-b, between which the second differential pair amplifiers 951 are coupled to. As indicated, all aspects described for these components in FIG. 6 apply to components described in FIG. 9.

Each differential pair amplifier of the plurality of differential pair amplifiers 911, 951 may have substantially the same layout, noting difference of couplings to the differential input and output connections. As depicted herein, a differential pair amplifier may include a pair of active devices, depicted as transistors connected in a common-source configuration illustratively. In some examples, the transistors may be connected in a common-gate configuration. A gate of a first transistor of each pair may be coupled to one of the differential input connections 902a-b, 906a-b associated with the respective array to receive a respective input signal and a source of the first transistor may be coupled to one of the differential output connections 901a-b, 905a-b associated with the respective array. A gate of a second transistor of each pair may be coupled to another one of the differential input connections 902a-b, 906a-b associated with the respective array to receive a respective input signal and a source of the second transistor may be coupled to another one of the differential output connections 901a-b, 905a-b. As illustrated herein, each differential pair may include at least one neutralizing component, as described.

In more detail, each first differential amplifier 911 may include a first transistor 915 and a second transistor 916 provided in a differential amplifier configuration. The first differential amplifiers 911 may be configured with a first differential pair configuration. Aspects described herein are provided for a common-source configuration, in which gates are to receive input signals and drains are to provide amplified output signals for a transistor, and accordingly gates and drains are referred to as input and output terminals respectively. Input terminal of the first transistor 915 may be coupled to a second input connection 902b of the first differential input connections and output terminal of the first transistor 915 may be coupled to a first output connection 901a of the first differential output connections. Similarly, input terminal of the second transistor 916 may be coupled to a first input connection 902a of the first differential input connections and output terminal of the second transistor 916 may be coupled to a second output connection 901b of the first differential output connections. This configuration may be referred to a configuration in which the close proximity connections have the same polarity, namely the first input connection 902a and the first output connection 901a have the same polarity for the magnetic coupling coefficient as both depicted here with plus "+" signs, and the second input connection 902b and the second output connection 901b have the same polarity for the magnetic coupling coefficient as both depicted here with plus "-" signs. As illustrated herein, each differential pair may include at least one neutralizing component, as described.

On the other hand, each second differential amplifier 951 may include a first transistor 955 and a second transistor 956 provided in a differential amplifier configuration. The second differential amplifiers 951 may be configured with a second differential pair configuration. Input terminal of the first transistor 955 may be coupled to a first input connection 906a of the second differential input connections and output terminal of the first transistor 955 may be coupled to a first output connection 905a of the second differential output connections. Similarly, input terminal of the second transistor 916 may be coupled to a second input connection 906b of the second differential input connections and output terminal of the second transistor 956 may be coupled to a second output connection 905b of the second differential output connections. This configuration may be referred to a configuration in which the close proximity connections have the opposite polarities, namely the first input connection 906a and the first output connection 905a have the opposite polarities for the magnetic coupling coefficient as they are depicted here with minus "-" and plus "+" signs respectively, and the second input connection 906b and the second output connection 905b have the opposite polarities for the magnetic coupling coefficient as they are depicted here with minus "-" and plus "+" signs respectively.

As illustrated herein, for each subarray of the first subarray 910 and the second subarray 950, differential mode parasitic inductance per the length D of close proximity connections including a differential input connection and a differential output connection is also shown as $L_i$ and $L_o$. Generally, the length D corresponding to a magnetic coupling coefficient as described herein, a differential pair amplifier (i.e. a first differential pair amplifier 911, or a second differential pair amplifier 951) may be disposed between the respective differential input and output connections within the length D as depicted herein, and the mutual magnetic coupling between $L_i$ and $L_o$ within each length D is denoted as k, as the magnetic coupling coefficient associated with the respective length D.

In some examples, the magnetic coupling coefficient may also be associated with the respective differential pair amplifiers. In a scenario, which identically structured differential pair amplifiers implemented as NDP cells, each length D and their corresponding magnetic coupling coefficient k may be considered substantially the same. It is further to be noted that based on the relative position of input terminals and output terminals in the layout as described herein, the sign of the magnetic coupling could be either positive or negative, which may be referred to a positive differential input or output connection or a negative differential input or output connection respectively, as described also in FIGs. 6 or 7.

Ideally, each length D may correspond to the same magnitude of magnetic coupling coefficient throughout the close proximity connections, and corresponding magnitude of magnetic coupling coefficient of a close proximity connection may be equal to another corresponding magnitude of magnetic coupling coefficient of another close proximity connection.

The amplifier circuitry may further include a connector 920, which is depicted as a twisting section to couple the first differential input connections 902a-b and the second differential input connections 906a-b. The connector 920 may include conductors, such as wires, traces, vias, etc. to provide connections as a twisting section. Noting the illustrated one-dimensional array with a twisting section complimenting the difference between the first and second differential pair configurations (i.e. the positions of the gate routings). Through the twisting section that swaps as illustrated, the first subarray 710 and the second subarray 750 may be coupled to each other across the twisting section. Noting that, through inclusion of equal number of differential pair amplifiers within the first subarray 710 and the second subarray 750, the magnitude of the magnetic feedback may be substantially the same in both subarrays, but with different polarity.

In this illustrative example, the first and second differential output connections 901a-b, 905a-b are connected to each other. In one example, aspects described herein for the first and second differential output connections 901a-b, 905a-b may be provided as a first single differential output connection including the first output connection 901a of the first differential output connections and the first output connection 905a of the first differential output connections, and a second single differential output connection including the second output connection 901b of the first differential output connections and the second output connection 905b of the second differential output connections.

The connector 920 may couple the first differential pair amplifiers 911, and the second differential pair amplifiers 951, such that each differential pair amplifier receives the differential input signals and provides its respective output signal based on the received differential input signals. In accordance with various aspects provided herein, the connector 920 may particularly couple the first differential input connections 602a-b and the second differential input connections 606a-b in a manner, such that magnetic feedback currents associated with the magnetic coupling between the first differential input connections 902a-b and the first differential output connections 901a-b and magnetic feedback currents associated with the magnetic coupling between the second differential input connections 906a-b and the second differential output connections 905a-b may mitigate (e.g. cancel out, at least partially), each other.

In accordance with various aspects provided herein, the connector 920 may couple the first differential input connections 902a-b and the second differential input connections 906a-b, such that a first magnetic coupling coefficient associated with the first magnetic coupling that is between the first differential output connections 901a-b and the first differential input connections 902a-b and a second magnetic coupling coefficient associated with the second magnetic coupling that is between the second differential output connections 905a-b and the second differential input connections 906a-b have opposite polarities. Namely, if the first magnetic coupling coefficient is positive, the second magnetic coupling coefficient is negative. Alternatively, if the first magnetic coupling coefficient is negative, the second magnetic coupling coefficient is positive.

As illustrated with different differential pair configurations for the first differential pair amplifiers 911 and the second differential pair amplifiers, the connector 920 may couple the first input connection 902a of the first differential input connections to the second input connection 906b of the second differential input connections. Further, the connector 920 may couple the second input connection 902b of the first differential input connections to the first input connection 906a of the second differential input connections.

FIG. 10 shows an exemplary illustration of a graph associated with simulated gain and stability factor associated with the amplifier circuitry described in FIG. 9. The graph illustrates simulated gain and stability factor with a twisting section between two differential pair configurations compared with a traditional amplifier circuitry including an NDP array, each calculated for an array size of 10, parasitic inductance Li=Lo=9pH and mutual magnetic coupling |K|=0.7 at 140GHz vs. Neutralizing capacitance $C_{nu}$ varied within each differential pair amplifier for three cases, 1011 depicts a first graph for all differential pair amplifiers are of the differential pair amplifier configuration, 1012 depicts a second graph for the amplifier circuitry as described in FIG. 9, with sub-arrays each including 5 differential pair amplifier in a respective differential pair configuration and connected in the middle using an ideal twisting section and with 1013 depicts a third graph of EM model of a real twisting section implemented in layout. The results may indicate that without twisting section, in 1011, the array is unstable with $\mu$-factor <1 for $C_{nu}$<1fF and has maximum stable gain <4dB. With ideal twisting section, in 1012, the array shows unconditional stability with $\mu$-factor>1 and higher gain of 8dB. With EM view of the twisting section, in 1013, the stability of the array is maintained, and the gain dropped further by 1dB accounting for its insertion loss.

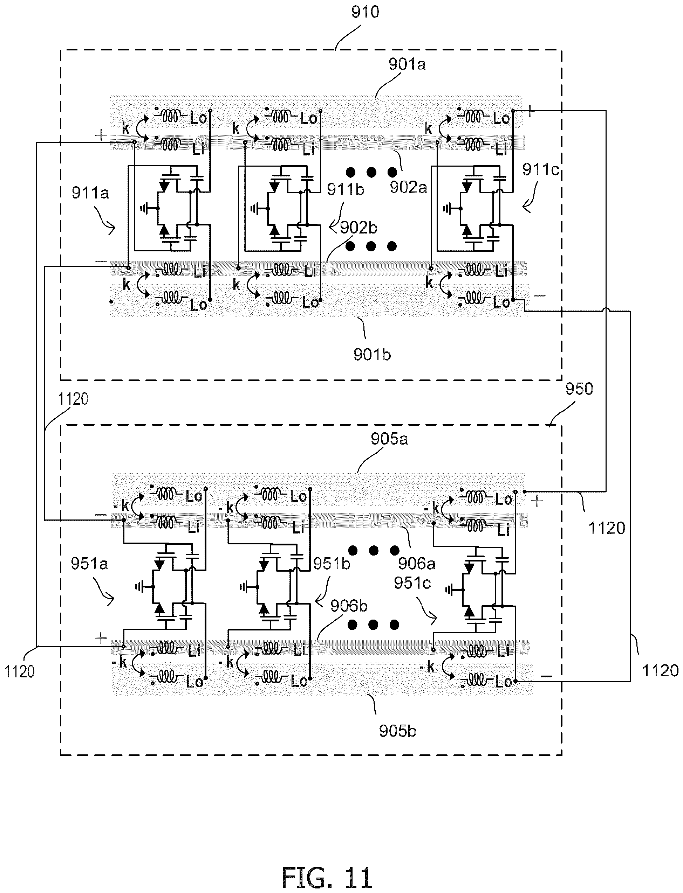

FIG. 11 shows schematically another exemplary illustration of two subarrays of an amplifier circuitry in accordance with various aspects of this disclosure. For brevity, aspects described herein according to aspects described in FIG. 9. Illustratively, the amplifier circuitry illustrated herein may include the first subarray 910 and the second subarray 950, together with the first and second differential input and output connections 901a-b, 902a-b, 905a-b, 906a-b described above.

In this example, the first subarray 910 may include multiple first differential pair amplifiers 91 1a-c, each being one of the first differential pair amplifiers as described above. The second subarray 950 may include multiple second differential pair amplifiers 951a-c, each being one of the second differential pair amplifiers as described above. The amplifier circuitry may further include first differential input connections 902a-b and first differential output connections 901a-b between which the first differential pair amplifiers 911 are coupled to. The amplifier circuitry may further include second differential input connections 906a-b and second differential output connections 905a-b, between which the second differential pair amplifiers 951 are coupled to. As described above, each differential pair amplifier of the plurality of differential pair amplifiers 911, 951 may be provided as described above. Illustratively, each differential pair amplifier of the first differential pair amplifiers 91 1a-c may include a differential pair in a first differential pair configuration. Similarly, each differential pair amplifier of the second differential pair amplifiers 951a-c may include a differential pair in a second differential pair configuration.

In this example, each subarray may include differential output connections 901a-b, 905a-b disposed to extend on a plane at a direction and the differential input connections 902a-b, 906a-b disposed between the differential output connections 901a-b, 905a-b and extend on the plane at the direction, which may be substantially parallel to the differential output connections 901a-b, 905a-b. The plurality of differential pair amplifiers 91 1a-c, 951a-c may further be disposed between the differential input connections 902a-b, 906a-b and extend on the plane at the direction, which may be substantially parallel to the differential output connections 901a-b, 905a-b and the differential input connections 902a-b.

In this illustrative example, the first subarray 910 may be disposed extending on the plane in a first row at the direction and the second subarray 950 may extend on the plane in a second row at the direction. The first subarray 910 and the second subarray 950 may extend in a substantially spatially parallel configuration. Through such an alignment as illustrated in FIG. 11, may be provided in multiple rows. Illustrated amplifier circuitry in FIG. 11 may be referred to as two-dimensional array in a parallel configuration.

The amplifier circuitry may further include a connector 1120, which may include multiple electrical connections, which may extend substantially perpendicular to the direction, in order to couple the first differential input connections 902a-b and the second differential input connections 906a-b. The connector 1120 may include conductors, such as wires, traces, vias, etc. to provide multiple connections. It is to be noted that the illustrated two-dimensional array in two rows compliments the difference between the first and second differential pair configurations (i.e. the positions of the gate routings). Through the illustrated connections, the first subarray 910 and the second subarray 950 may be coupled to each other. Noting that, through inclusion of equal number of differential pair amplifiers within the first subarray 910 and the second subarray 950, the magnitude of the magnetic feedback may be substantially the same in both subarrays, but with different polarity.

In this illustrative example, the first output connection 901a of the first differential output connections may be coupled to the first output connection 905a of the second differential output connections. The second output connection 901b of the first differential output connections may be coupled to the second output connection 905b of the second differential output connections. The first input connection 902a of the first differential input connections may be coupled to the second input connection 906b of the second differential input connections. The second input connection 902b of the first differential input connections may be coupled to the first input connection 906a of the second differential input connections.

In accordance with various aspects provided herein, the connector 1120 may couple the first differential input connections 902a-b and the second differential input connections 906a-b, such that a first magnetic coupling coefficient associated with the first magnetic coupling that is between the first differential output connections 901a-b and the first differential input connections 902a-b and a second magnetic coupling coefficient associated with the second magnetic coupling that is between the second differential output connections 905a-b and the second differential input connections 906a-b have opposite polarities. Namely, if the first magnetic coupling coefficient is positive, the second magnetic coupling coefficient is negative. Alternatively, if the first magnetic coupling coefficient is negative, the second magnetic coupling coefficient is positive.

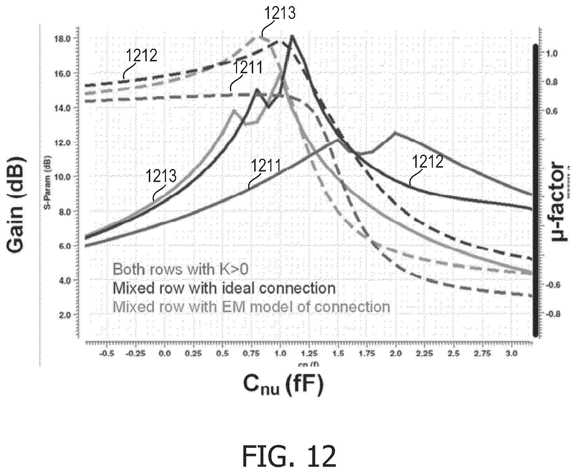

FIG. 12 shows an exemplary illustration of a graph associated with simulated gain and stability factor associated with the amplifier circuitry described in FIG. 11. The simulations are for an array having an array size of 14 with sizes of each the first array 910 and the second array 950 may be 7 in each row. The parasitic inductance may be Li=L0=9pH and |K|=0.7.

As illustrated with different differential pair configurations for the first differential pair amplifiers 1211 and the second differential pair amplifiers, the connector 1220 may couple the first input connection 1202a of the first differential input connections to the second input connection 1206b of the second differential input connections. Further, the connector 1220 may couple the second input connection 1202b of the first differential input connections to the first input connection 1206a of the second differential input connections.

The graph shows simulated gain at 140GHz and $\mu$-factor (stability) of the array vs. neutralizing capacitance $C_{nu}$ for three cases; in 1201, a first graph is provided for the scenario if both sub-arrays are formed using a traditional NDP variant without first and second differential pair configurations. In 1202, a second graph is provided for the amplifier circuitry illustrated in FIG.11. In 1203, with the EM model of the parallel connection between the sub-arrays. The simulated gain at 140GHz and the $\mu$-factor (stability) across the $C_{nu}$ is plotted. The result may indicate that for the first case in 1201, the NDP array is unstable with $\mu$-factor<1 across $C_{nu}$ and cannot be used in a PA design. In both second and third cases, represented by 1202 and 1203 respectively, due to magnetic feedback cancellation the corresponding NDP arrays showed a stability with maximum gain of 14dB and 13dB (1dB gain drop accounting for insertion loss of the parallel connection) respectively.

The detailed description refers to the accompanying drawings that show, by way of illustration, specific details and aspects of this disclosure in which the disclosure may be practiced. Other aspects may be utilized and structural, logical, and electrical changes may be made without departing from the scope of the disclosure. The various aspects of this disclosure are not necessarily mutually exclusive, as some aspects of this disclosure can be combined with one or more other aspects of this disclosure to form new aspects.

The word "exemplary" is used herein to mean "serving as an example, instance, or illustration". Any aspect of the disclosure or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The words "plurality" and "multiple" in the description or the claims expressly refer to a quantity greater than one. The terms "group (of)", "set [of]", "collection (of)", "series (of)", "sequence (of)", "grouping (of)", etc., and the like in the description or in the claims refer to a quantity equal to or greater than one, i.e. one or more. Any term expressed in a plural form that does not expressly state "plurality" or "multiple" likewise refers to a quantity equal to or greater than one.

As used herein, "memory" is understood as a non-transitory computer-readable medium in which data or information can be stored for retrieval. References to "memory" included herein may thus be understood as referring to volatile or non-volatile memory, including random access memory ("RAM"), read-only memory ("ROM"), flash memory, solid-state storage, magnetic tape, hard disk drive, optical drive, etc., or any combination thereof. Furthermore, registers, shift registers, processor registers, data buffers, etc., are also embraced herein by the term memory. A single component referred to as "memory" or "a memory" may be composed of more than one different type of memory, and thus may refer to a collective component including one or more types of memory. Any single memory component may be separated into multiple collectively equivalent memory components, and vice versa. Furthermore, while memory may be depicted as separate from one or more other components (such as in the drawings), memory may also be integrated with other components, such as on a common integrated chip or a controller with an embedded memory.

In the context of this disclosure, the term "process" may be used, for example, to indicate a method. Illustratively, any process described herein may be implemented as a method (e.g., a channel estimation process may be understood as a channel estimation method). Any process described herein may be implemented as a non-transitory computer readable medium including instructions configured, when executed, to cause one or more processors to carry out the process (e.g., to carry out the method).

"The terms "at least one" and "one or more" may be understood to include a numerical quantity greater than or equal to one (e.g., one, two, three, four, [...], etc.). The term "a plurality" may be understood to include a numerical quantity greater than or equal to two (e.g., two, three, four, five, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (e.g., "plural [elements]", "multiple [elements]") referring to a quantity of elements expressly refers to more than one of the said elements. The terms "group (of)", "set (of)", "collection (of)", "series (of)", "sequence (of)", "grouping (of)", etc., and the like in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, e.g., provided as a file, a portion of a file, a set of files, a signal or stream, a portion of a signal or stream, a set of signals or streams, and the like. Further, the term "data" may also be used to mean a reference to information, e.g., in form of a pointer. The term "data", however, is not limited to the aforementioned examples and may take various forms and represent any information as understood in the art.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (e.g., the transmission of radio signals) and logical transmission (e.g., the transmission of digital data over a logical software-level connection). For example, a processor or controller may transmit or receive data over a software-level connection with another processor or controller in the form of radio signals, where the physical transmission and reception is handled by radio-layer components such as RF transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both 'direct' calculations via a mathematical expression/formula/relationship and 'indirect' calculations via lookup or hash tables and other array indexing or searching operations.

Throughout the drawings, it should be noted that like reference numbers are used to depict the same or similar elements, features, and structures, unless otherwise noted.

The phrase "at least one" and "one or more" may be understood to include a numerical quantity greater than or equal to one (e.g., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

As used herein, unless otherwise specified the use of the ordinal adjectives "first", "second", "third" etc., to describe a common object, merely indicate that different instances of like objects are being referred to, and are not intended to imply that the objects so described must be in a given sequence, either temporally, spatially, in ranking, or in any other manner.

As used herein, a signal that is "indicative of" a value or other information may be a digital or analog signal that encodes or otherwise communicates the value or other information in a manner that can be decoded by and/or cause a responsive action in a component receiving the signal. The signal may be stored or buffered in computer readable storage medium prior to its receipt by the receiving component and the receiving component may retrieve the signal from the storage medium. Further, a "value" that is "indicative of" some quantity, state, or parameter may be physically embodied as a digital signal, an analog signal, or stored bits that encode or otherwise communicate the value.

As used herein, a signal may be transmitted or conducted through a signal chain in which the signal is processed to change characteristics such as phase, amplitude, frequency, and so on. The signal may be referred to as the same signal even as such characteristics are adapted. In general, so long as a signal continues to encode the same information, the signal may be considered as the same signal. For example, a transmit signal may be considered as referring to the transmit signal in baseband, intermediate, and radio frequencies.

The terms "processor" or "controller" as, for example, used herein may be understood as any kind of technological entity that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, logic circuit, processor, microprocessor, Central Processing Unit (CPU), Graphics Processing Unit (GPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As utilized herein, terms "module", "component," "system," "circuit," "element," "slice," "circuitry," and the like are intended to refer to a set of one or more electronic components, a computer-related entity, hardware, software (e.g., in execution), and/or firmware. For example, circuitry or a similar term can be a processor, a process running on a processor, a controller, an object, an executable program, a storage device, and/or a computer with a processing device. By way of illustration, an application running on a server and the server can also be circuitry. One or more circuits can reside within the same circuitry, and circuitry can be localized on one computer and/or distributed between two or more computers. A set of elements or a set of other circuits can be described herein, in which the term "set" can be interpreted as "one or more."

The term "antenna" or "antenna structure", as used herein, may include any suitable configuration, structure and/or arrangement of one or more antenna elements, components, units, assemblies and/or arrays. In some aspects, the antenna may implement transmit and receive functionalities using separate transmit and receive antenna elements. In some aspects, the antenna may implement transmit and receive functionalities using common and/or integrated transmit/receive elements. The antenna may include, for example, a phased array antenna, a single element antenna, a set of switched beam antennas, and/or the like.

It will be understood that when an element is referred to as being "connected" or "coupled" to another element, it can be physically connected or coupled to the other element such that current and/or electromagnetic radiation (e.g., a signal) can flow along a conductive path formed by the elements. Intervening conductive, inductive, or capacitive elements may be present between the element and the other element when the elements are described as being coupled or connected to one another. Further, when coupled or connected to one another, one element may be capable of inducing a voltage or current flow or propagation of an electro-magnetic wave in the other element without physical contact or intervening components. Further, when a voltage, current, or signal is referred to as being "applied" to an element, the voltage, current, or signal may be conducted to the element by way of a physical connection or by way of capacitive, electro-magnetic, or inductive coupling that does not involve a physical connection.

The following examples pertain to further aspects of this disclosure.

In example 1, the subject matter includes an amplifier circuitry that may include: a first plurality of differential pair amplifiers connected to first differential input connections and first differential output connections, wherein the first differential input connections and the first differential output connections extend on a plane and are associated with a first magnetic coupling; a second plurality of differential pair amplifiers connected to second differential input connections and second differential output connections, wherein the second differential input connections and the second differential output connections extend on the plane and are associated with a second magnetic coupling; and a connector connected to the first plurality of differential pair amplifiers and the second plurality of differential pair amplifiers, and configured to mitigate (e.g. cancel out, at least partially), first magnetic feedback currents associated with the first magnetic coupling with second magnetic feedback currents associated with the second magnetic coupling.

In example 2, the subject matter of example 1, wherein the first differential input connections include a first positive differential input connection and a first negative differential input connection; wherein the second differential input connections include a second positive differential input connection and a second negative differential input connection; wherein the connector is configured to: couple the first positive differential input connection and the second positive differential input connection; and couple the first negative input connection and the second negative differential input connection.

In example 3, the subject matter of example 2, wherein the first magnetic coupling includes a magnetic coupling between the first differential input connections and the first differential output connections provided with the same polarity; wherein the second magnetic coupling includes a magnetic coupling between the second differential input connections and the second differential output connections provided with the opposite polarities.

In example 4, the subject matter of example 2, wherein the first plurality of differential pair amplifiers and the second plurality of differential pair amplifiers are provided in different differential pair configurations extending on the plane; wherein the connector includes a first twisting component to couple the first positive differential input connection and the second positive differential input connection, and a second twisting component to couple the first negative differential input connection and the second negative differential input connection.

In example 5, the subject matter of example 3, wherein the first differential output connections are interconnected to the second differential output connections.

In example 6, the subject matter of example 2, wherein the first plurality of differential pair amplifiers are provided at a first configuration extending on the plane within a first row; wherein the second plurality differential pair amplifiers are provided at a second configuration extending on the plane within a second row.

In example 7, the subject matter of any one of examples 2 to 6, wherein the first magnetic coupling may include a magnetic coupling between a positive differential output connection of the first differential output connections and the positive differential input connection.

In example 8, the subject matter of any one of examples 2 to 7, wherein the second magnetic coupling may include a magnetic coupling between the positive differential output connection and the second negative differential input connection.

In example 9, the subject matter of any one of examples 2 to 8, wherein each differential pair of the first plurality of differential pair amplifiers is disposed between a corresponding length of the first positive differential input connection and the first negative differential input connection; wherein a corresponding first magnetic coupling coefficient is associated with a magnetic coupling between each corresponding length of the first positive differential input connection and the positive differential output connection.

In example 10, the subject matter of example 9, wherein each differential pair of the first plurality of differential pair amplifiers is disposed between a corresponding length of the first negative differential input connection and the first positive differential input connection; wherein a corresponding second magnetic coupling coefficient is associated with a magnetic coupling between each corresponding length of the first negative differential input connection and a first negative differential output connection of the first differential output connections; and wherein the corresponding first magnetic coupling coefficient and the corresponding second magnetic coupling coefficient exhibit the same polarities.

In example 11, the subject matter of example 10, wherein a magnitude of the first magnetic coupling coefficient and a magnitude of the second magnetic coupling coefficient are substantially equal.

In example 12, the subject matter of example 10 or example 11, wherein the first magnetic coupling includes a magnetic coupling between the first negative differential output connection and the first negative differential input connection.

In example 13, the subject matter of any one of examples 10 to 12, wherein the first magnetic coupling includes a magnetic coupling between the first positive differential output connection and the first positive differential input connection.

In example 14, the subject matter of any one of examples 10 to 13, wherein each differential pair of the second plurality of differential pair amplifiers are disposed between a corresponding length of the second positive differential input connection and the second negative differential input connection; wherein a corresponding third magnetic coupling coefficient is associated with a magnetic coupling between each corresponding length of the second negative differential input connection and a second positive differential output connection of the second differential output connections.

In example 15, the subject matter of example 14, wherein each differential pair of the second plurality of differential pair amplifiers are disposed between a corresponding length of the second negative differential input connection and the second positive differential input connection; wherein a corresponding fourth magnetic coupling coefficient is associated with a magnetic coupling between each corresponding length of the second positive differential input connection and a second negative differential output connection of the second differential output connections; and wherein the corresponding third magnetic coupling coefficient and the corresponding fourth magnetic coupling coefficient exhibit the same polarities.

In example 16, the subject matter of example 15, wherein a magnitude of the third magnetic coupling coefficient and a magnitude of the fourth magnetic coupling coefficient are substantially equal.

In example 17, the subject matter of example 16, wherein the magnitude of the third magnetic coupling coefficient and the magnitude of the first magnetic coupling coefficient are substantially equal; wherein the third magnetic coupling coefficient and the first magnetic coupling coefficient have opposite signs.

In example 18, the subject matter of any one of examples 10 to 17, wherein a number of the first plurality of differential pair amplifiers and a number of the second plurality of differential pair amplifiers are equal.

In example 19, the subject matter of any one of examples 1 to 18, wherein each differential pair of the first plurality of differential pair amplifiers and the second plurality of differential pair amplifiers is a corresponding neutralized differential pair.

In example 20, the subject matter of any one of examples 1 to 19, wherein each differential pair of the first plurality of differential pair amplifiers and the second plurality of differential pair amplifiers includes a corresponding neutralizing component configured to neutralize a parasitic capacitance.

In example 21, the subject matter of any one of examples 1 to 20, wherein the first plurality of differential pair amplifiers is coupled in a parallel configuration; and wherein the second plurality of differential pair amplifiers are coupled in a parallel configuration.

In example 22, the subject matter of any one of examples 1 to 21, wherein each differential pair of amplifier of the first plurality of pairs of amplifiers and the second plurality of pairs of amplifiers includes a corresponding common-source amplifier or a corresponding common-gate amplifier may include a first transistor and a second transistor.

In example 23, the subject matter of example 22, wherein respective drains of the first and second transistors of the first plurality of pairs of amplifiers are coupled to the first differential output connections; wherein respective drains of the first and second transistors of the second plurality of pairs of amplifiers are coupled to the second differential output connections.

In example 24, the subject matter of example 22, may include differential input terminals coupled to the first and second differential input connections configured to receive a signal; may include differential output terminals coupled to the first and second differential output connections configured to output an amplified signal.

In example 25, the subject matter of example 24, wherein the received signal includes a radio frequency (RF) signal.

In example 26, the subject matter of example 25, wherein the RF signal includes a millimeter wave signal or a sub-Terahertz signal.

In example 27, an amplifier circuitry may include: a positive differential output connection and a negative differential output connection, wherein the positive and negative differential output connections extends on a plane; a first positive differential input connection and a first negative differential input connection provided between the positive differential output connection and the negative differential output connection; a first plurality of differential pair amplifiers connected between the first positive differential input connection and the first negative differential input connection in a first configuration; a second positive differential input connection and a second negative differential input connection provided between the positive differential output connection and the negative differential output connection; a second plurality of differential pair amplifiers connected between the positive differential input connection and the negative differential input connection in a second configuration; wherein the first positive differential input connection is coupled to the second positive differential input connection and the first negative differential input connection is coupled to the second negative differential input connection.

In example 28, the subject matter of example 27, wherein the amplifier circuitry may include further aspects as provided in this disclosure, in particular in any one of examples 2 to 26.

In example 29, an amplifier circuitry may include: a first positive differential output connection and a first negative differential output connection, wherein the first positive and negative differential output connections extend on a plane; a first positive differential input connection and a first negative differential input connection provided between the first positive differential output connection and the first negative differential output connection; a first plurality of differential pair amplifiers connected between the first positive differential input connection and the first negative differential input connection in a first differential pair configuration; a second positive differential output connection and a second negative differential output connection, wherein the second positive and negative differential output connections extend on the plane and disposed substantially parallel to the first positive and negative differential output connections; a second positive differential input connection and a second negative differential input connection provided between the second positive differential output connection and the second negative differential output connection; a second plurality of differential pair amplifiers connected between the second positive differential input connection and the second negative differential input connection in a second differential pair configuration; wherein the first positive differential input connection is connected to the second positive differential input connection and the first negative differential input connection is connected to the second negative differential input connection.

In example 30, the subject matter of example 28, wherein the amplifier circuitry may include further aspects as provided in this disclosure, in particular in any one of examples 2 to 26.

In example 31, the subject matter includes an amplifier circuitry that may include: a first differential amplifier means connected between first differential input connections and first differential output connections, wherein the first differential input connections and the first differential output connections extend on a plane and are associated with a first magnetic coupling; a second differential amplifier means connected between second differential input connections and second differential output connections, wherein the second differential input connections and the second differential output connections extend on the plane and are associated with a second magnetic coupling; and a coupling means connected to the first plurality of differential amplifier means and the second plurality of differential amplifier means, and configured to mitigate (e.g. cancel out, at least partially), first magnetic feedback currents associated with the first magnetic coupling with second magnetic feedback currents associated with the second magnetic coupling.

In example 32, the subject matter of example 31, wherein the first differential input connections include a first positive differential input connection and a first negative differential input connection; wherein the second differential input connections include a second positive differential input connection and a second negative differential input connection; wherein the coupling means is configured to: couple the first positive differential input connection and the second positive differential input connection; and couple the first negative input connection and the second negative differential input connection.

In example 33, the subject matter of example 32, wherein the first magnetic coupling includes a magnetic coupling between the first differential input connections and the first differential output connections provided with the same polarity; wherein the second magnetic coupling includes a magnetic coupling between the second differential input connections and the second differential output connections provided with the opposite polarities.

In example 34, the subject matter of example 32, wherein the first plurality of differential amplifier means and the second plurality of differential amplifier means are provided in different differential pair configurations extending on the plane; wherein the coupling means includes a first twisting component to couple the first positive differential input connection and the second positive differential input connection, and a second twisting component to couple the first negative differential input connection and the second negative differential input connection.

In example 35, the subject matter of example 33, wherein the first differential output connections are interconnected to the second differential output connections.

In example 36, the subject matter of example 32, wherein the first plurality of differential amplifier means are provided at a first configuration extending on the plane within a first row; wherein the second plurality differential amplifier means are provided at a second configuration extending on the plane within a second row.

In example 37, the subject matter of any one of examples 32 to 36, wherein the first magnetic coupling may include a magnetic coupling between a positive differential output connection of the first differential output connections and the positive differential input connection.

In example 38, the subject matter of any one of examples 32 to 37, wherein the second magnetic coupling may include a magnetic coupling between the positive differential output connection and the second negative differential input connection.

In example 39, the subject matter of any one of examples 32 to 38, wherein each differential pair of the first plurality of differential amplifier means is disposed between a corresponding length of the first positive differential input connection and the first negative differential input connection; wherein a corresponding first magnetic coupling coefficient is associated with a magnetic coupling between each corresponding length of the first positive differential input connection and the positive differential output connection.

In example 40, the subject matter of example 39, wherein each differential pair of the first plurality of differential amplifier means is disposed between a corresponding length of the first negative differential input connection and the first positive differential input connection; wherein a corresponding second magnetic coupling coefficient is associated with a magnetic coupling between each corresponding length of the first negative differential input connection and a first negative differential output connection of the first differential output connections; and wherein the corresponding first magnetic coupling coefficient and the corresponding second magnetic coupling coefficient exhibit the same polarities.

In example 41, the subject matter of example 40, wherein a magnitude of the first magnetic coupling coefficient and a magnitude of the second magnetic coupling coefficient are substantially equal.

In example 42, the subject matter of example 40 or example 41, wherein the first magnetic coupling includes a magnetic coupling between the first negative differential output connection and the first negative differential input connection.

In example 43, the subject matter of any one of examples 40 to 42, wherein the first magnetic coupling includes a magnetic coupling between the first positive differential output connection and the first positive differential input connection.

In example 44, the subject matter of any one of examples 40 to 43, wherein each differential pair of the second plurality of differential amplifier means are disposed between a corresponding length of the second positive differential input connection and the second negative differential input connection; wherein a corresponding third magnetic coupling coefficient is associated with a magnetic coupling between each corresponding length of the second negative differential input connection and a second positive differential output connection of the second differential output connections.

In example 45, the subject matter of example 44, wherein each differential pair of the second plurality of differential amplifier means are disposed between a corresponding length of the second negative differential input connection and the second positive differential input connection; wherein a corresponding fourth magnetic coupling coefficient is associated with a magnetic coupling between each corresponding length of the second positive differential input connection and a second negative differential output connection of the second differential output connections; and wherein the corresponding third magnetic coupling coefficient and the corresponding fourth magnetic coupling coefficient exhibit the same polarities.

In example 46, the subject matter of example 45, wherein a magnitude of the third magnetic coupling coefficient and a magnitude of the fourth magnetic coupling coefficient are substantially equal.

In example 47, the subject matter of example 46, wherein the magnitude of the third magnetic coupling coefficient and the magnitude of the first magnetic coupling coefficient are substantially equal; wherein the third magnetic coupling coefficient and the first magnetic coupling coefficient have opposite signs.

In example 48, the subject matter of any one of examples 40 to 47, wherein a number of the first plurality of differential amplifier means and a number of the second plurality of differential amplifier means are equal.

In example 49, the subject matter of any one of examples 31 to 48, wherein each differential pair of the first plurality of differential amplifier means and the second plurality of differential amplifier means is a corresponding neutralized differential pair.

In example 50, the subject matter of any one of examples 31 to 49, wherein each differential pair of the first plurality of differential amplifier means and the second plurality of differential amplifier means includes a corresponding neutralizing component configured to neutralize a parasitic capacitance.

In example 51, the subject matter of any one of examples 31 to 50, wherein the first plurality of differential amplifier means is coupled in a parallel configuration; and wherein the second plurality of differential amplifier means are coupled in a parallel configuration.

In example 52, the subject matter of any one of examples 31 to 51, wherein each differential pair amplifiers of the first plurality of pairs of amplifiers and the second plurality of pairs of amplifiers includes a corresponding common-source amplifier or a corresponding common-gate amplifier may include a first transistor and a second transistor.

In example 53, the subject matter of example 52, wherein respective drains of the first and second transistors of the first plurality of pairs of amplifiers are coupled to the first differential output connections; wherein respective drains of the first and second transistors of the second plurality of pairs of amplifiers are coupled to the second differential output connections.

In example 54, the subject matter of example 52, may include differential input terminals coupled to the first and second differential input connections configured to receive a signal; may include differential output terminals coupled to the first and second differential output connections configured to output an amplified signal.

In example 55, the subject matter of example 54, wherein the received signal includes a radio frequency (RF) signal.

In example 56, the subject matter of example 55, wherein the RF signal includes a millimeter wave signal or a sub-Terahertz signal.

It is appreciated that implementations of methods detailed herein are exemplary in nature, and are thus understood as capable of being implemented in a corresponding device. Likewise, it is appreciated that implementations of devices detailed herein are understood as capable of being implemented as a corresponding method. It is thus understood that a device corresponding to a method detailed herein may include one or more components configured to perform each aspect of the related method.

All acronyms defined in the above description additionally hold in all claims included herein.

**Claims**

1. An amplifier circuitry comprising:

   a first plurality of differential pair amplifiers connected to first differential input connections and first differential output connections, wherein the first differential input connections and the first differential output connections configured to extend on a plane and are associated with a first magnetic coupling;
   a second plurality of differential pair amplifiers connected to second differential input connections and second differential output connections, wherein the second differential input connections and the second differential output connections are configured to extend on the plane and are associated with a second magnetic coupling; and
   a connector connected to the first plurality of differential pair amplifiers and the second plurality of differential pair amplifiers, and configured to mitigate first magnetic feedback currents associated with the first magnetic coupling with second magnetic feedback currents associated with the second magnetic coupling.

2. The amplifier circuitry of claim 1,

   wherein the first differential input connections comprise a first positive differential input connection and a first negative differential input connection;
   wherein the second differential input connections comprise a second positive differential input connection and a second negative differential input connection; and
   wherein the connector is configured to:

      couple the first positive differential input connection and the second positive differential input connection; and
      couple the first negative input connection and the second negative differential input connection;

   preferably wherein the first magnetic coupling comprises a magnetic coupling between the first differential input connections and the first differential output connections provided with the same polarity; and

wherein the second magnetic coupling comprises a magnetic coupling between the second differential input connections and the second differential output connections provided with opposite polarities.

3. The amplifier circuitry of claim 2,

wherein the first plurality of differential pair amplifiers and the second plurality of differential pair amplifiers are provided in different differential pair configurations extending on the plane; and

wherein the connector comprises a first twisting component to couple the first positive differential input connection and the second positive differential input connection, and a second twisting component to couple the first negative differential input connection and the second negative differential input connection.

4. The amplifier circuitry of claim 3, wherein the first differential output connections are interconnected to the second differential output connections.

5. The amplifier circuitry of claim 2,

wherein the first plurality of differential pair amplifiers is provided at a first configuration extending on the plane within a first row; and

wherein the second plurality differential pair amplifiers is provided at a second configuration extending on the plane within a second row.

6. The amplifier circuitry of any one of claims 2 to 5,

wherein the first magnetic coupling comprises a magnetic coupling between a positive differential output connection of the first differential output connections and the positive differential input connection; and

wherein the second magnetic coupling comprises a magnetic coupling between the positive differential output connection and the second negative differential input connection.

7. The amplifier circuitry of claim 6,

wherein each differential pair of the first plurality of differential pair amplifiers is disposed between a corresponding length of the first positive differential input connection and the first negative differential input connection; and

wherein a corresponding first magnetic coupling coefficient is associated with a magnetic coupling between each corresponding length of the first positive differential input connection and the positive differential output connection.

8. The amplifier circuitry of claim 7,

wherein each differential pair of the first plurality of differential pair amplifiers is disposed between a corresponding length of the first negative differential input connection and the first positive differential input connection;

wherein a corresponding second magnetic coupling coefficient is associated with a magnetic coupling between each corresponding length of the first negative differential input connection and a first negative differential output connection of the first differential output connections; and

wherein the corresponding first magnetic coupling coefficient and the corresponding second magnetic coupling coefficient exhibit the same polarities.

9. The amplifier circuitry of claim 8,

wherein the first magnetic coupling comprises a magnetic coupling between the first negative differential output connection and the first negative differential input connection; and

wherein the first magnetic coupling comprises a magnetic coupling between the positive differential output connection and the first positive differential input connection.

10. The amplifier circuitry of any one of claims 8 or 9,

wherein each differential pair of the second plurality of differential pair amplifiers are disposed between a corresponding length of the second positive differential input connection and the second negative differential input connection; and

wherein a corresponding third magnetic coupling coefficient is associated with a magnetic coupling between each corresponding length of the second negative differential input connection and a second positive differential output connection of the second differential output connections.

11. The amplifier circuitry of claim 10,

wherein each differential pair of the second plurality of differential pair amplifiers are disposed between a corresponding length of the second negative differential input connection and the second positive differential input connection;

wherein a corresponding fourth magnetic coupling coefficient is associated with a magnetic coupling between each corresponding length of the second positive differential input connection and a second negative differential output connection of the second differential output connections; and

wherein the corresponding third magnetic coupling coefficient and the corresponding fourth magnetic coupling coefficient exhibit the same polarities.

12. The amplifier circuitry of claim 11,

wherein a magnitude of the third magnetic coupling coefficient and the magnitude of the first magnetic coupling coefficient are substantially equal; and

wherein the third magnetic coupling coefficient and the first magnetic coupling coefficient have opposite signs.

13. The amplifier circuitry of any one of claims 1 to 12, wherein each differential pair of the first plurality of differential pair amplifiers and the second plurality of differential pair amplifiers is a corresponding neutralized differential pair.

14. The amplifier circuitry of any one of claims 1 to 13, wherein each differential pair of the first plurality of differential pair amplifiers and the second plurality of differential pair amplifiers comprises a corresponding neutralizing component configured to neutralize a parasitic capacitance.

15. The amplifier circuitry of any one of claims 1 to 14,

wherein the first plurality of differential pair amplifiers is coupled in a parallel configuration; and

wherein the second plurality of differential pair amplifiers are coupled in a parallel configuration.

**FIG. 1**

**FIG. 2**

322

PROCESSOR
310

325

RF TRANSCEIVER
320

325

300

## FIG. 3

PA
401

CIRCUIT

403

LNA
402

400

## FIG. 4

MIXER CIRCUIT 501

SYNTHESIZER CIRCUIT 502

FILTER CIRCUIT 503

PROCESSING CIRCUIT 504

AMPLIFIER CIRCUITRY 505

ADC CIRCUIT 506

DAC CIRCUIT 507

OTHER 508

500

# FIG. 5

600

620

601a

605a

602a

606a

IN OUT

DIFFERENTIAL PAIR 611a

IN OUT

IN OUT

DIFFERENTIAL PAIR 611b

IN OUT

IN OUT

DIFFERENTIAL PAIR 611c

IN OUT

IN OUT

DIFFERENTIAL PAIR 651a

IN OUT

IN OUT

DIFFERENTIAL PAIR 651b

IN OUT

IN OUT

DIFFERENTIAL PAIR 651c

IN OUT

602b

606b

601b

605b

# FIG. 6

FIG. 7

EP 4 572 139 A1

FIG. 8A

FIG. 8B

FIG. 9

FIG. 10

FIG. 11

FIG. 12

Europäisches
Patentamt

European
Patent Office

Office européen
des brevets

# EUROPEAN SEARCH REPORT

**Application Number**

EP 24 20 9790

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2008/174371 A1 (AGHAHASSAN HOUSHANG [US] ET AL) 24 July 2008 (2008-07-24) * paragraph [0022] - paragraph [0035]; figures 1-7 * | 1-15 | INV. H03F3/45 H03F3/195 H03F1/14 |
| A | US 2005/030103 A1 (LANDOLT OLIVER D [US]) 10 February 2005 (2005-02-10) * paragraph [0024] - paragraph [0066]; figures 1-12B * | 1-15 | |
| A | US 2020/144976 A1 (DASGUPTA KAUSHIK [US] ET AL) 7 May 2020 (2020-05-07) * paragraph [0083] - paragraph [0092]; figure 17 * | 1-15 | |

**TECHNICAL FIELDS SEARCHED (IPC)**

H03F

The present search report has been drawn up for all claims

| Place of search | Date of completion of the search | Examiner |
|---|---|---|
| The Hague | 11 April 2025 | Wienema, David |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 20 9790

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2025

| Patent document cited in search report | Publication date | Patent family member(s) | Publication date |
|---|---|---|---|
| US 2008174371 A1 | 24-07-2008 | NONE | |
| US 2005030103 A1 | 10-02-2005 | NONE | |
| US 2020144976 A1 | 07-05-2020 | CN 112912977 A | 04-06-2021 |
| | | DE 112019005485 T5 | 22-07-2021 |
| | | US 2020144976 A1 | 07-05-2020 |
| | | US 2021313943 A1 | 07-10-2021 |
| | | US 2022038069 A1 | 03-02-2022 |
| | | WO 2020091937 A1 | 07-05-2020 |

EPO FORM P0459

For more details about this annex : see Official Journal of the European Patent Office, No. 12/82